# EUROPEAN PATENT SPECIFICATION

(11) **EP 2 916 637 B1**
(45) Date of publication and mention of the grant of the patent: **08.04.2020**
(21) Application number: 12887348.6
(22) Date of filing: 30.10.2012
(51) Int. Cl.: H05K 13/08, H05K 13/04

(54) **NOZZLE MANAGING APPARATUS**
DÜSENVERWALTUNGSVORRICHTUNG
APPAREIL DE GESTION DE BUSES

(43) Date of publication of application: 09.09.2015
(60) Divisional application: 20160594.6
(73) Proprietor: FUJI Corporation, Chiryu Aichi (JP)
(72) Inventor: SHIMOSAKA, Kenji, Chiryu Aichi (JP); TESHIMA, Chikashi, Chiryu Aichi (JP); HOSHIKAWA, Kazumi, Chiryu Aichi (JP); TSUJI, Hisayuki, Chiryu Aichi (JP); HOSAKA, Hideki, Chiryu Aichi (JP); KOMIYAMA, Nobuhisa, Chiryu Aichi (JP)
(74) Representative: Grünecker Patent- und Rechtsanwälte PartG mbB
(86) International application number: PCT/JP2012/078044
(87) International publication number: WO 2014/068673

(56) References cited:
- EP-A1- 0 552 922
- JP-A- H0 823 192
- JP-A- H0 846 392
- JP-A- H0 846 392
- JP-A- 10 305 263
- JP-A- 2002 111 286
- JP-A- 2003 298 286
- JP-A- 2004 311 599
- JP-A- 2006 108 384
- JP-A- 2007 027 233
- JP-A- 2012 004 306
- JP-A- 2012 114 237
- US-B1- 6 223 425

## Description

### Technical Field

The present invention relates to a nozzle management machine that manages suction nozzles used to hold an electrical component in an electrical component mounting machine.

### Background Art

In most electrical component mounting machines, electrical components are held by suction nozzles when the electrical components are mounted on a circuit board. Using suitable suction nozzles in such an electrical component mounting machine is important for mounting accuracy of electrical components to be highly maintained. In the related art, a technique is disclosed in PTL 1 which is related to washing of suction nozzles and techniques disclosed in PTL 2 and PTL 3 which are related to inspection of suction nozzles.

### Citation List

### Patent Literature

PTL 1: JP-A-2012-114237
PTL 2: JP-A-2012-4306
PTL 3: JP-A-2010-258185
PTL 4: US 6 223 425 B1 discloses a nozzle management machine according to the preamble of independent claim 1.

### Summary of Invention

### Technical Problem

As understood from the fact that PTLs described above are present, it is necessary to suitably manage suction nozzles for suitable use of the suction nozzles. For this reason, a nozzle management machine capable of performing suitable management of suction nozzles, particularly, a nozzle management machine with high practicality has been demanded. The invention has been made in consideration of the above-described problem and an object thereof is to provide a nozzle management machine with high practicality.

### Solution to Problem

In order to solve the above-described problem, there is provided a nozzle management machine according to the features of independent claim 1. Preferred embodiments are laid down in the dependent claims.

### Advantageous Effects of Invention

According to the invention, it is possible to realize a nozzle management machine with high practicality by elaborating the nozzle storing device and proving means for carrying out various treatments on suction nozzles stored in a storing device.

### Brief Description of Drawings

[Fig. 1] Fig. 1 is a perspective view illustrating an electrical component mounting machine in which suction nozzles serving as targets of management of a nozzle management machine of an example are used.
[Fig. 2] Fig. 2 is a perspective view illustrating a typical suction nozzle.
[Fig. 3] Fig. 3 is a view illustrating a nozzle tray on which suction nozzles are placed in an electrical component mounting machine.
[Fig. 4] Fig. 4 is a perspective view illustrating the appearance of a nozzle management machine of an example.
[Fig. 5] Fig. 5 is a perspective view illustrating the internal structure of a nozzle management machine.
[Fig. 6] Fig. 6 is a perspective view illustrating the internal structure of the nozzle management machine from a different viewpoint.
[Fig. 7] Fig. 7 is a perspective view for describing a nozzle transfer device included in a nozzle management machine .
[Fig. 8] Fig. 8 is a perspective view for describing a first nozzle inspecting device included in a nozzle management machine.
[Fig. 9] Fig. 9 is a perspective view for describing a second nozzle inspecting device included in a nozzle management machine.
[Fig. 10] Fig. 10 is a perspective view for describing a nozzle washing device and a nozzle drying device included in a nozzle management machine.
[Fig. 11] Fig. 11 is a perspective view illustrating the nozzle washing device and the nozzle drying device illustrated in Fig. 10 in a state in which a housing is eliminated therefrom.
[Fig. 12] Fig. 12 is a view illustrating a nozzle pallet on which suction nozzles are placed in a nozzle storing device included in a nozzle management machine.
[Fig. 13] Fig. 13 is a view illustrating several suction nozzles managed by a nozzle management machine.
[Fig. 14] Fig. 14 is a cross-sectional view illustrating a state in which a suction nozzle is placed in a placing hole and illustrating a part of a nozzle pallet of another placing hole which can be employed.
[Fig. 15] Fig. 15 is a schematic view for describing tip portion state inspection by a first nozzle inspecting device included in a nozzle management machine.
[Fig. 16] Fig. 16 is a schematic view for describing necessary retreat force inspection of a first nozzle inspecting device included in a nozzle management machine.
[Fig. 17] Fig. 17 is a schematic view for describing passing flow rate inspection and identifier reading inspection by a second nozzle inspecting device included in a nozzle management machine.
[Fig. 18] Fig. 18 is a schematic view for describing washing and drying of suction nozzle performed by a nozzle washing device and a nozzle drying device included in a nozzle management machine.
[Fig. 19] Fig. 19 is a table schematically illustrating information related to stored nozzle, which is stored in a control device of a nozzle management machine.
[Fig. 20] Fig. 20 is a table schematically illustrating information related to a stored tray, which is stored in a control device of a nozzle management machine.
[Fig. 21] Fig. 21 is a table schematically illustrating information related to setting of nozzles, which is used at the time of setting suction nozzles in a nozzle tray by a control device of a nozzle management machine.
[Fig. 22] Fig. 22 is a flowchart illustrating a nozzle storing program executed by a nozzle management machine in order to perform a nozzle storing operation.
[Fig. 23] Fig. 23 is a flowchart illustrating a nozzle setting program executed by a nozzle management machine in order to perform a nozzle setting operation.
[Fig. 24] Fig. 24 is a flowchart illustrating a first half part of a nozzle resetting program executed by a nozzle management machine in order to perform a nozzle resetting operation.
[Fig. 25] Fig. 25 is a flowchart illustrating a second half of the nozzle resetting program executed by the nozzle management machine in order to perform the nozzle resetting operation.
[Fig. 26] Fig. 26 is a flowchart illustrating a nozzle washing program executed the nozzle management machine in order to perform a nozzle washing operation.
[Fig. 27] Fig. 27 is a flowchart illustrating a first nozzle inspecting program executed by the nozzle management machine in order to perform a first nozzle inspecting operation.
[Fig. 28] Fig. 28 is a flowchart illustrating a second nozzle inspecting program executed by the nozzle management machine in order to perform a second nozzle inspecting operation.
[Fig. 29] Fig. 29 is a block diagram illustrating a configuration of functions of a control device included in a nozzle management machine.

### Description of Embodiments

Hereinafter, typical embodiments of the claimable invention will be described in detail with reference to the accompanying drawings as examples. In addition, the claimable invention can be carried out in various aspects to which various modifications and improvement are added based on the knowledge of a person skilled in the art in addition to aspects described in the sections of "aspects of invention" other than examples described below. Further, it is possible to form modification examples of examples described below using technical matters described in each section of "aspects of invention."

### Examples

A nozzle management machine of Examples manages suction nozzles being used in an electrical component mounting machine . The suction nozzles are component holding jigs that adsorb and hold electrical components using a negative pressure supplied to the suction nozzles in mounting of the electrical components on a circuit board. Before description of the nozzle management machine of Examples is made, the electrical component mounting machine and the suction nozzles will be simply described, and then the nozzle management machine of Examples, for example, the overall configuration of the nozzle management machine, each device constituting the nozzle management machine, several operations performed by the nozzle management machine, and the configuration of functions of a control device related to those operations will be sequentially described. Further, in the description below, the "nozzle management machine," the "electrical component mounting machine," the "suction nozzles," the "circuit board," and the "electrical components" are simply referred to as the "management machine," the "mounting machine," the "nozzles," the "board," and the "components" respectively.

### [A] Electrical component mounting machine and suction nozzles

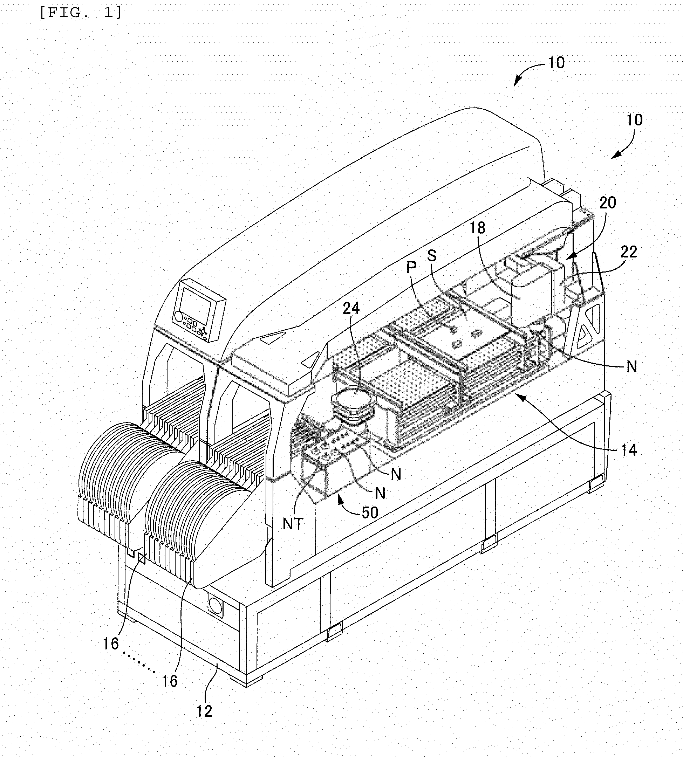

Fig. 1 illustrates an electrical component mounting machine for which suction nozzles serving as targets of management of a management machine are used as an example. In the figure, two mounting machines 10 having the same structure are disposed parallel to a base 12 (in the figure, an exterior panel positioned in the front side is eliminated). The mounting machine 10 includes a conveyor type board conveyance device 14 that transports a board S and fixes the board S to a set position; a plurality of feeder type component supply devices 16, each of which supplies a component P; a mounting head 18 that mounts the component P supplied from the component supply devices 16 on the fixed board S; and a head moving device 20 that moves the mounting head 18 between the component supply device 16 and the fixed board S. The mounting head 18 includes an operational axis 22 whose lower end portion is attached by suction nozzles N; and an operational axis elevating and rotating device (not illustrated) that elevates and rotates the operational axis 22. In addition, the mounting head 18 illustrated in the figure is an index type of mounting head and a plurality of nozzles N is detachably attached to the operational axis 22. The component P supplied from the component supply device 16 is adsorbed and held in the tip (lower end) of the nozzle N, and the held component P is mounted on the board S when the mounting head 18 is moved to the upper side of the board S and then the components is released from the state of being adsorbed and held by the nozzle N. In addition, since the component P is mounted in a suitable posture in a suitable position on the board S, the component P is imaged by a component camera 24 provided in the mounting machine 10 from the lower side in a state of being adsorbed and held by the nozzle N and data of a holding position and a holding posture obtained by capturing an image is used at the time of mounting.

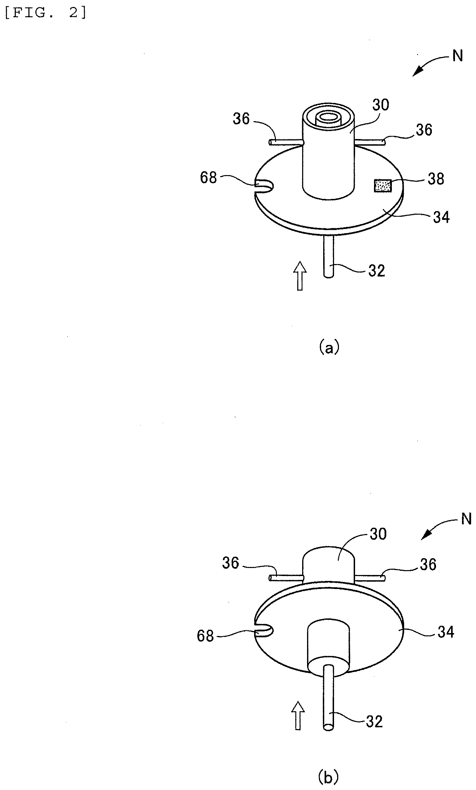

The nozzles N are targets to be managed of the management machine and the nozzles N are illustrated in Fig. 2. Fig. 2 (a) is a view illustrating the nozzles N when seen from the obliquely upper side and Fig. 2(b) is a view illustrating the nozzles N when seen from the obliquely lower side. As understood from the figures, the nozzles N include a cylindrical barrel tube 30 functioning as a main body portion of the nozzles N; a suction pipe 32 extending to the lower side from the barrel tube 30; and a flange 34 stretching to the vicinity of the barrel tube 30 and fixed to the barrel tube 30. The upper end portion of the barrel tube 30 functions as a base end portion of the nozzle N and is held by the operational axis on the upper end portion. The suction pipe 32 functions as a tip portion of the nozzle and has a shape of a relatively thin pipe. Two interlocking pins 36 are extended to the barrel tube 30 and the nozzles N are attached to the operational axis 22 using those interlocking pins 36. A technique of attaching the nozzles N using the interlocking pins 36 is a general technique and the description here is not described and the description in other figures is also omitted.

A positive pressure and a negative pressure are selectively provided through the barrel tube 30 to the suction pipe 32 from the mounting head 18 . The component P is adsorbed and held by the tip (lower end) of the suction pipe 32 due to the negative pressure being supplied and the adsorbed and held component P is separated from the suction pipe 32 due to the positive pressure being supplied. In the figure, the internal structure thereof is not described, but the suction pipe 32 is configured so as to advance and retreat with respect to the barrel tube 30. Specifically, the tip portion of the nozzle N is biased by the spring force in an advancing direction from the barrel tube 30 in order to alleviate an impact added to the component P when the component P is mounted on the board S, and the tip portion thereof can be retreated, that is, retracted with respect to the barrel tube 30 in a case where a force greater than the biasing force is added thereto. In addition, the flange 34 functions as a rear surface forming member in order to make a clear image at the time when the component P is imaged by the component camera 22 and the flange 34 is a portion having the largest outer diameter in the nozzle N. A two-dimensional code 38 is attached to the upper surface of the flange 34 as an identifier for recognizing the specific information of the nozzles N. The two-dimensional code 38 show the ID of the nozzles N as a kind of the specific information and the ID is used for individual management of the nozzles N.

Although only one kind of nozzle is illustrated in the figure, various kinds of nozzles N whose size and shapes are different from one another are present. Even in the mounting machine 10, several kinds of nozzles N whose size is different from one another can be attached to the operational axis 16 and the several kinds of nozzles can be automatically exchanged according to the component P to be adsorbed and held in the mounting machine 10. In addition, the nozzles N to be used vary according to the electrical circuit (circuit in which the component P is mounted on the board S) to be produced. In addition, a plurality of nozzles N to be used in the mounting machine 10 are arranged in a nozzle station 50 provided in the mounting machine 10 on the side of the component supply device 16 in a state of being mounted on the nozzle tray NT.

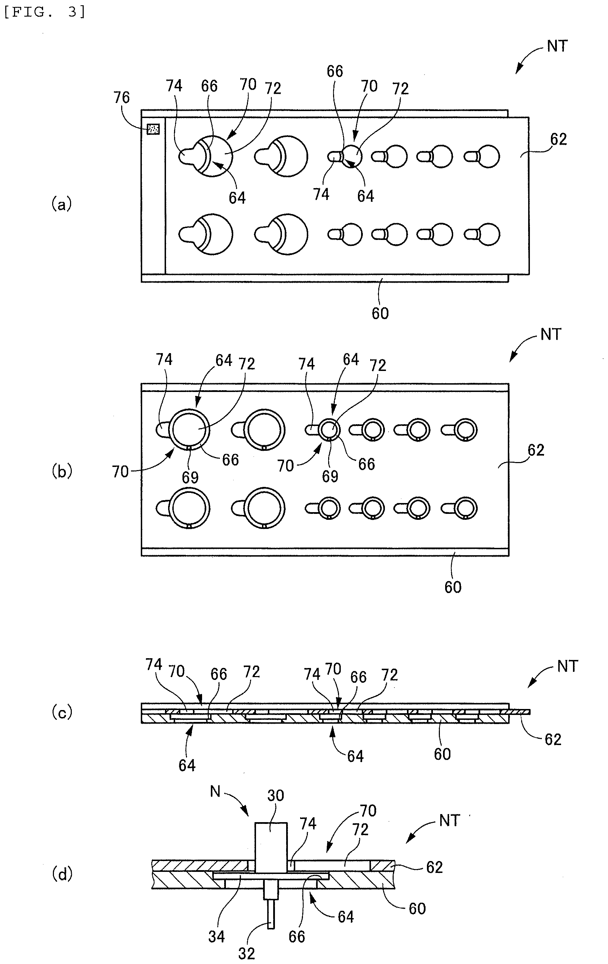

The nozzle tray (hereinafter, simply referred to as the "tray" in some cases) NT functions as a nozzle placing device for placing the nozzles N and general has a plate shape as illustrated in Fig. 3. Specifically, the tray NT includes a base plate 60 and a cover plate 62 that covers the upper surface of the base plate 60, and the cover plate 62 is configured to be slidable with respect to the base plate 60 in a certain range . Fig. 3(a) illustrates a state in which the cover plate 62 is displaced with respect to the base plate 60 and Fig. 3(b) illustrates a state in which the cover plate 62 exactly overlaps the base plate 60. The cover plate 62 is configured so as to be slidable between respective positions of the two states.

When the description is made with reference to Fig. 3 (c) which is a cross-sectional view and Fig. 3 (d) which is a partial cross-sectional view illustrating a state of the nozzles N being placed, twelve placing holes 64, each of which constitutes a placing unit, are provided in the base plate 60. Specifically, two kinds of nozzles N whose size is different from each other can be placed on the tray NT, and four placing holes 64 for placing the nozzles N whose size is large and four placing holes 64 for placing the nozzles N whose size is small are provided in the tray NT. The placing hole 64 is a stepped hole in which the dimension of the inner peripheral wall is different in the depth thereof and a stepped surface 66 is a surface on which the flange 34 of the nozzle N is placed. The inner diameter of the placing hole 64 in the upper surface of the base plate 60, that is, the maximum inner diameter thereof is slightly greater than the outer diameter of the flange 34, and the placing hole 64 is configured so as to regulate the displacement (shift) of the nozzles N in the diameter direction in the outer periphery of the flange 34. In addition, the depth to the stepped surface is a depth in which the cover plate 62 is not interrupted by the flange 34 of the nozzles N placed on the placing hole 64. In addition, the nozzles N illustrated in the figure have the flange 34 which is thinner than the depth to the stepped surface and the upper surface of the flange 34 does not protrude more than the upper surface of the base plate 60 of the tray NT in the nozzles N in the state of being placed on the placing hole 64. As understood from Fig. 2, a notch 68 is provided in the outer periphery of the flange 34 and the notch 68 is engaged with a short pin 69 erected on the stepped surface 66. The nozzles N can be placed only in a specific direction due to the notch 68 and the pin 69 and rotation of nozzles N in the state of being placed on the tray NT is prevented.

Meanwhile, a loophole 70 is provided in the cover plate 62 in correspondence with the placing hole 64 of the base plate 60. The loophole 70 is formed of a circular hole portion 72 having a shape of a cycle and a slot portion 74 extending from one side of the circular hole portion 72. The inner diameter of each circular hole portion 72 is approximately equivalent to the maximum inner diameter of the corresponding placing hole 64 . The width of the slot portion 74 is greater than the outer diameter, to some extent, of the barrel tube 30 of the nozzle N placed on the corresponding placing hole 64. In the state illustrated in Fig. 3(b), the center of each placing hole 64 coincides with the center of the circular portion 72 of the corresponding loophole 70 and the whole placing holes 64 can be seen from the upper side. Meanwhile, in the state of Fig. 3(a), the center of each placing hole 64 approximately coincides with the center of an arc present in the tip of the slot portion 74 of the corresponding loophole 70, and only a part of the placing hole 64 can be seen from the upper side. These two states are as described above and thus, conveniently, the state of Fig. 3(b) is referred to as a "placing hole open state" and the state of Fig. 3(a) is referred to as a "placing hold in a closed state."

The nozzle N can be placed on the placing hold 64 of the nozzle N and separated from the placing hold 64 in the placing hole open state. Meanwhile, by putting the placing hole into the placing hold in a closed state when the nozzle N is placed on the placing hold 64, the barrel tube 30 of the nozzle N is inserted to the slot portion 74 of the loophole 70 and many portions on the upper surface of the flange 34 are covered by the cover plate 62. In this state, the separation of the nozzles N from the placing hole 64 is prevented. In regard to the prevention of the separation of the nozzles N, a mechanism formed by including the cover plate 62, that is, a nozzle separation preventing mechanism which is referred to as a so-called "shutter mechanism" is provided in the tray NT.

The cover plate 62 is biased so as putting a placing hole into placing hold in a closed state by a spring (not illustrated) and putting the placing hole into the placing hole open state by allowing the cover plate 62 to slide with a force greater than the biasing force of the spring. Although not illustrated, the sliding is performed by the cover sliding mechanism disposed in the nozzle station 50. The nozzles N are attached to the operational axis of the mounting head 18 and removed from the operational axis, and the nozzles N being attached thereto are exchanged for other nozzles N when the placing hole open state is realized by the control device of the mounting machine 10 controlling the cover sliding mechanism.

The tray NT is detachably attached to the nozzle station 50 and, for example, the tray NT on which the nozzles N are placed in advance can be set in the nozzle station 50 when production of an electrical circuit is started. Further, for example, the entire tray NT on which the nozzles N being used are placed can be removed from the nozzle station 50 when the production of an electrical circuit is finished. Accordingly, the tray NT markedly contributes to speedup such as retooling of the mounting machine 10. In addition, in the tray NT, the two-dimensional code 76 is attached to one corner of the base plate 60 as an identifier for recognizing the specific information of the tray NT. The two-dimensional code 76 shows the ID of the tray NT as a kind of the specific information and the ID is used for individual management of the tray NT.

Further, the suction nozzles N and the tray NT described above are used for the mounting machine 10. The management device of Examples described below uses not only nozzles N used for the mounting machine 10 but also nozzles N used for another mounting machine as targets. In addition, the above-described tray NT is an example of the tray NT used for the mounting machine 10 and the mounting machine 10 can use other trays NT which are different from one another according to the kind thereof. Moreover, trays NT to be used are different from one another according to mounting machines. As will be described below, the mounting machine of Examples uses the nozzles N mounted or to be mounted on another tray NT as targets.

### [B] Overall configuration of nozzle management machine

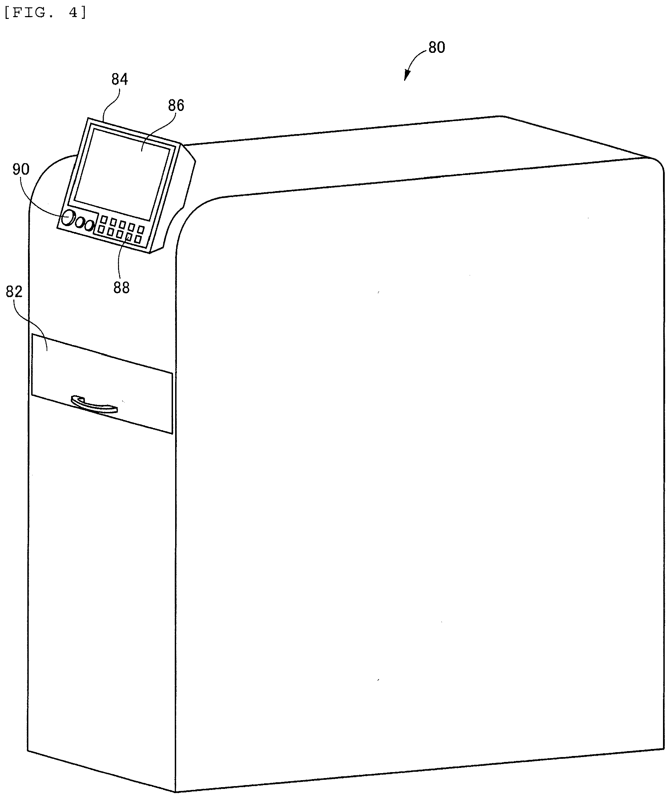

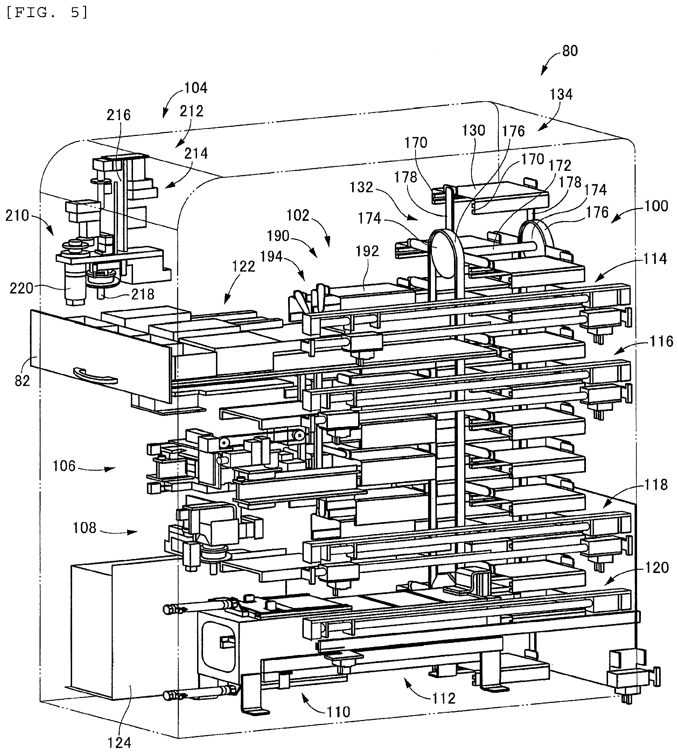

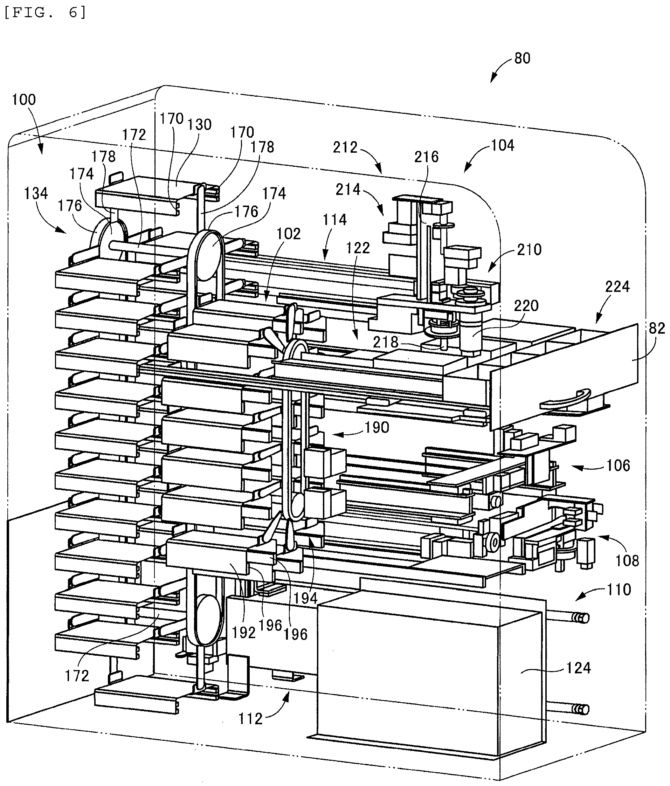

As the outer appearance is illustrated in Fig. 4, the management machine 80 of Examples has a shape of a square and the size thereof is relatively compact. A drawer 82, which will be described below in detail, is provided on the front surface (surface on the left side of the figure) of the management machine 80. Moreover, a controller 84 is attached to the upper portion of the front surface as a control device of the management machine 80. The controller 84 uses a computer as a main constituent element and includes input and output devices such as a display 86, an operation key 88, and a switch 90. Fig. 5 illustrates a management machine 80 in a state in which an exterior panel is removed and Fig. 6 illustrates the management machine 80 when seen from the opposite direction. Hereinafter, the internal structure of the management machine 80 will be described with reference to these figures. Further, in Fig. 5, the left side of the figure is the front side of the management machine 80 and the right side thereof is the rear side of the management machine 80.

The management machine 80 is configured by combining several devices. Specifically, the nozzle storing device 100 that stores the nozzles N is disposed on the rear side in a state of being placed on a nozzle pallet (hereinafter, simply referred to as a "pallet" in some cases) and a tray storing device 102 that stores the tray NT is disposed on the front left side of the nozzle storing device 100. Further, in order from the upside, the nozzle transfer device 104, the first nozzle inspecting device 106, the second nozzle inspecting device 108, and the nozzle washing device 110 are disposed on the front side of the management machine 80 as devices for performing a treatment on nozzles that perform any process with respect to the nozzles N (hereinafter, referred to as a "treatment on nozzles") stored or to be stored in the nozzle storing device 100.

Simply stated, the nozzle transfer device 104 is a device that transfers nozzles N between the tray NT and the pallet. The first nozzle inspecting device 106 performs inspection on two items, specifically, inspection related to the state of tip portion of the nozzle N (tip portion state inspection) and inspection related to necessary retreat force of the tip portion of the nozzle N (necessary retreat force inspection) and the second nozzle inspecting device 108 performs inspection on two items, specifically, inspection related to the flow rate of air passing through the nozzle N (passing flow rate inspection) and inspection related to reading the two-dimensional code 38 as an identified attached to the flange 34 of the nozzle N (identifier reading inspection) . The nozzle washing device 110 is a device washing the nozzles N with high-pressure water. In addition, the nozzle drying device 112 that dries the nozzles N washed by the nozzle washing device 110 is disposed between the nozzle storing device 100 and the nozzle washing device 110.

The transfer of the nozzles N between each device for performing a treatment on nozzles and each nozzle storing device 100 is performed by each nozzle transfer device corresponding to each device for performing a treatment on nozzles. Since the transfer of the nozzles N is performed in a state of being placed on the pallet, each of the nozzle transfer devices is used as a pallet transfer device. Specifically, a first pallet transfer device 114 that transfers a pallet between the nozzle transfer device 104 and the nozzle storing device 100; a second pallet transfer device that transfers a pallet between the first nozzle inspecting device 106 and the nozzle storing device 100; a third pallet transfer device 118 that transfers a pallet between the second nozzle inspecting device 108 and the nozzle storing device 100; and a fourth pallet transfer device 120 that transfers a pallet between the nozzle washing device 110 and the nozzle storing device 100 are respectively disposed. Meanwhile, a tray transfer device 122 that transfers the tray NT between the nozzle transfer device 104 and the tray storing device 102 is disposed therebetween. Further, a driving source unit 124 in which power sources for each device described above, a driving circuit, an air compressor, and a high-pressure pump are incorporated is disposed on the front side and the lower portion of the management machine 10.

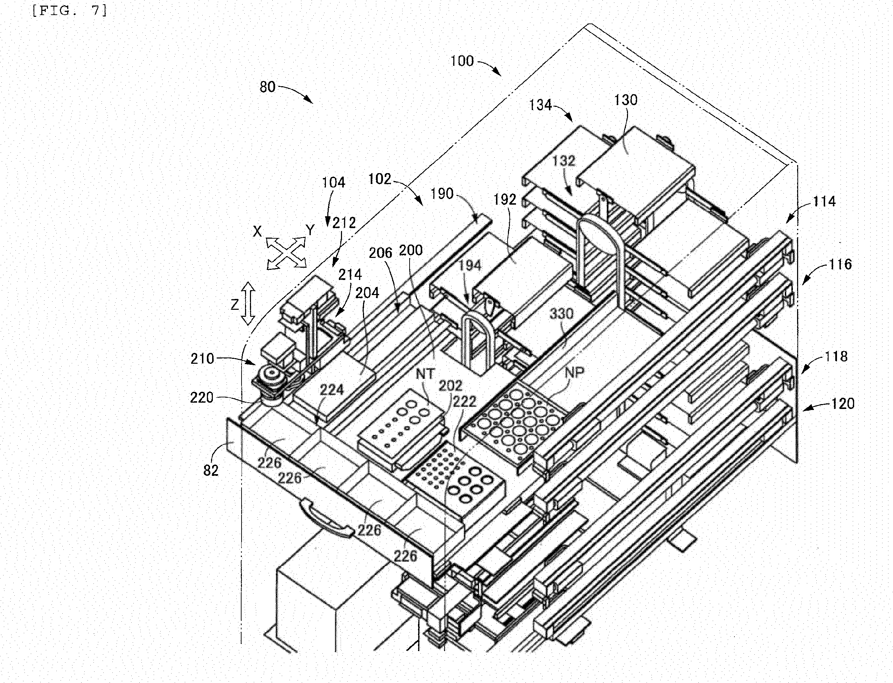

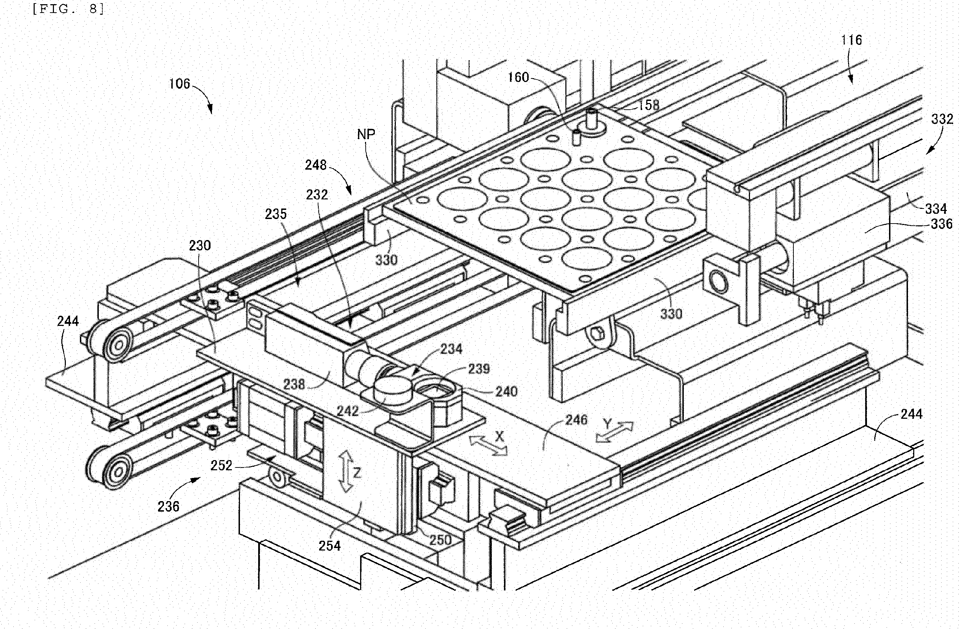

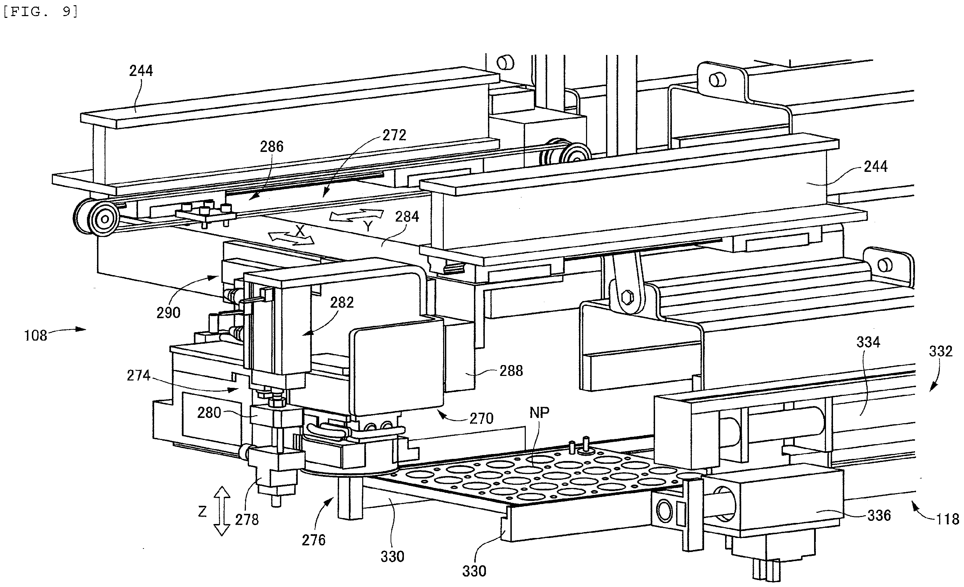

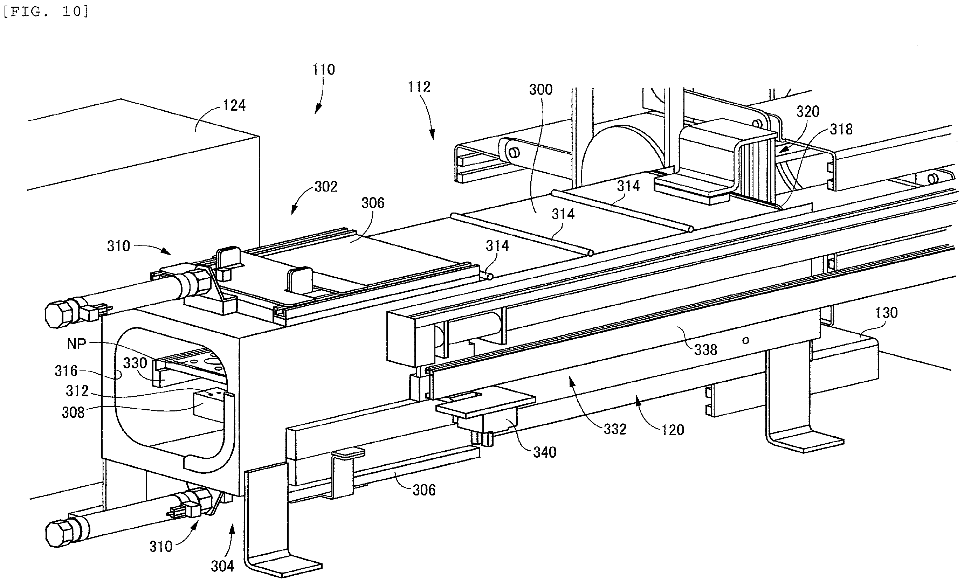

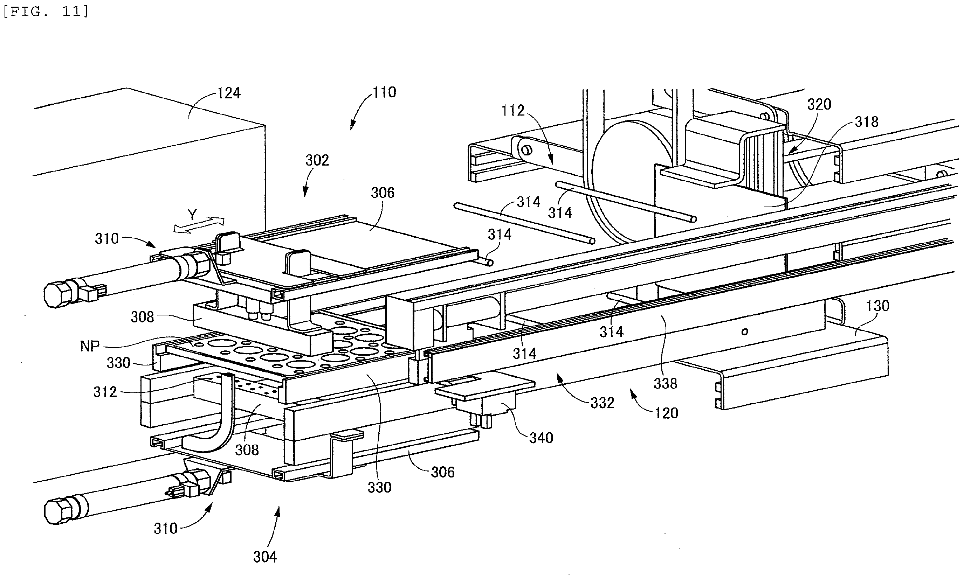

Moreover, in the description below, the nozzle storing device, the tray storing device, the nozzle transfer device, the nozzle inspection device, the nozzle washing device, the nozzle drying device, the pallet transfer device, and the tray transfer device are respectively referred to as the "storing device," the "storing device," the "transfer device," the "inspection device," the "washing device," the "drying device," the "transfer device," and the "transfer device" in some cases. In addition, the description below will be made with reference to Fig. 7 illustrating the transfer device 104, Fig. 8 illustrating the first inspection device 106, Fig. 9 illustrating the second inspection device 108, and Figs 10 and 11 illustrating the washing device 110 and the drying device 112.

### [C] Nozzle storing device

The nozzle storing device 100 includes a plurality of pallet carriers (hereinafter, also simply referred to as a "carrier") 130 in which the above-described pallets are respectively stored and a carrier circulating mechanism (hereinafter, also simply referred to as a "circulating mechanism") 132 that circulates the carriers 130, and a pallet moving device (hereinafter, also simply referred to as a "moving device") 134 that moves a plurality of pallets in the storing device 130 is configured by the plurality of carriers 130 and a circulating mechanism 132. Hereinafter, the storing device 100 will be described by dividing pallets and a moving device 134.

### i) Nozzle pallet

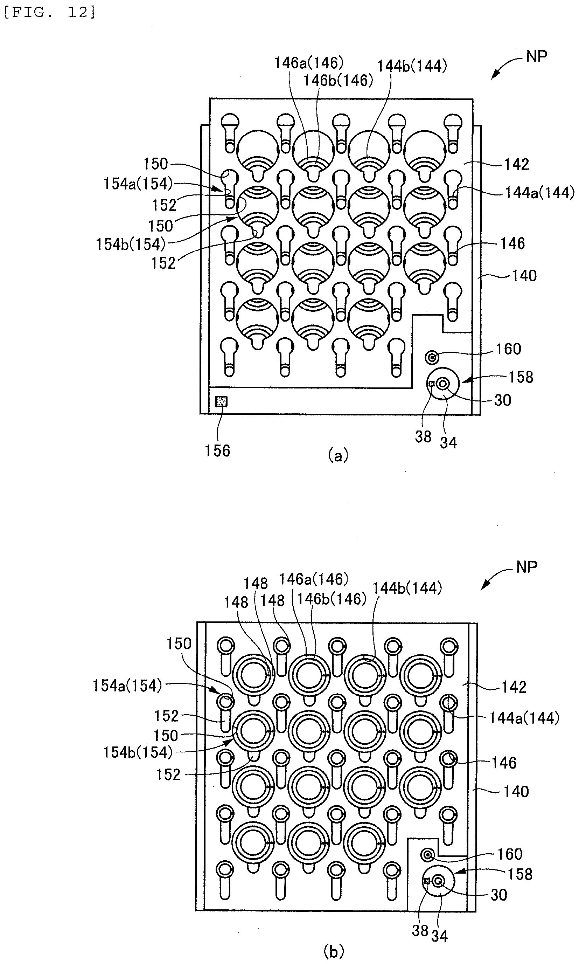

The pallet NP functions as a nozzle placing device for placing the nozzles N and includes a base plate 140 and a cover plate 142 that covers the upper surface of the base plate 140 as illustrated in Fig. 12 in the same manner as that of the tray NT described above. Fig. 12(a) illustrates a state in which the cover plate 142 is displaced with respect to the base plate 140 and Fig. 12(b) illustrates a state the cover plate 142 exactly overlaps the base plate 140. The cover plate 142 is configured so as to be slidable between respective positions of the two states.

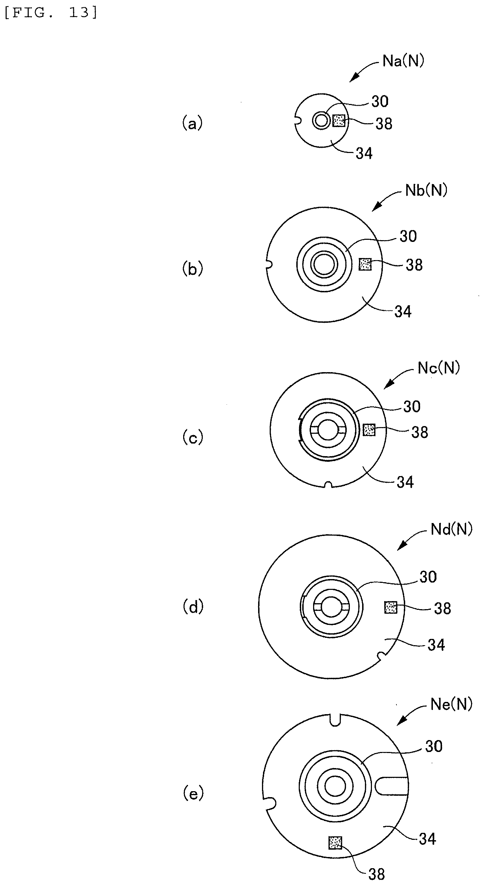

Conveniently, in the management machine 80, when five kinds of nozzles N illustrated in Fig. 13 are used as the targets of the management, all five kinds of nozzles N can be placed on the pallet NP. Five kinds of nozzles N are different from each other in terms of the shape and can be classified into three kinds in terms of the outer diameter of the flange 34. Fig. 13 is a view when the nozzles N are seen from the upper side and, specifically, the nozzles N can be classified into a nozzle Na whose size is small illustrated in Fig. 13(a); nozzles Nb and Nc whose size is medium illustrated in Figs. 13(b) and 13(c); and nozzles Nd and Ne whose size is large illustrated in Figs. 13(d) and 13(e). Placing holes 144 respectively constituting a placing unit are provided in the base plate 140 in the same manner as that of the tray NT. Specifically, twenty four placing holes 144a on which small nozzles N are placed and fifteen placing holes 144b on which large nozzles N are placed are provided and the nozzles Na are placed on the placing hole 144a and the nozzles Nb, Nc, Nd, and Ne are placed on the placing hole 114b.

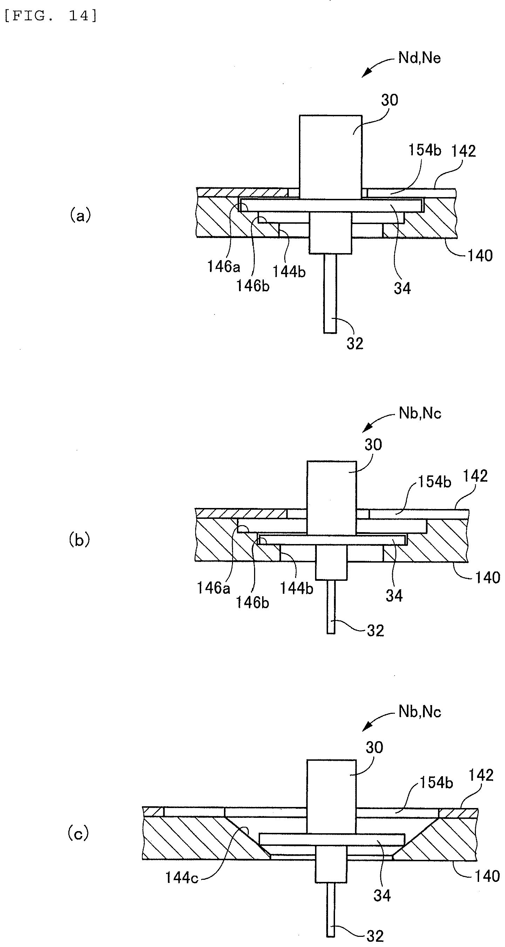

Since the placing hole 144a has one stepped surface 146 similar to the placing hole 64 of the tray NT described above, the description thereof is not repeated. When description of the placing hole 144b is made with reference to Fig. 14 illustrating a state of placing the nozzles N, the placing hole 144b is a stepped hole in which the dimension of the inner peripheral wall is different in the depth thereof and, specifically, a stepped hold having two stepped surfaces 146a and 146b. As illustrated in Fig. 14 (a), nozzles Nd and Ne whose size is large are placed on the stepped surface 146a positioned on the upper side. Meanwhile, as illustrated in Fig. 14(b), the nozzles Nb and Nc whose size is medium are placed on the stepped surface 146b positioned on the lower side. That is, both stepped surface 146a and 146b are surfaces on which the nozzles N are placed. In the placing hole 144b, the internal dimension of the inner peripheral wall is different in the depth direction and the flange 34 of plural kinds of nozzles N which are different in the outer diameter of the flange 34 are configured so as to be embedded in the position with different depths. In addition, the placing hole 144b is configured so as to regulate the displacement (shift) of the nozzles N in the diameter direction in the outer periphery of the flange 34 with respect to all nozzles N. A pin 148 engaging with the notch 68 of the flange 34 is erected on both stepped surfaces 146a and 146b for the purpose of preventing rotation of the nozzles N.

Further, in place of the placing hole 144b in a form in which the above-described plurality of stepped surfaces 146 are included, as illustrated in Fig. 14(c), a tapered placing hole 144c whose inner dimension of the inner peripheral wall is reduced in the axis direction, that is, in the depth direction can be employed. Even in the case of the placing hold 144c, the flange 34 of the plural kinds of nozzles N which are different in the outer diameter of the flange 34 is embedded in a portion having depths different from each other. In addition, the figure illustrates the state of placing the nozzles Nb and Nc whose size is medium. In a case of the nozzles Nd and Ne whose size is large are placed, the nozzles Nd and Ne are placed in a position upper than the position of the nozzles Nb and Nc.

Meanwhile, loopholes 154a and 154b respectively having a circular portion 150 and a slot portion 152 are provided in the cover plate 142 in correspondence with the placing holes 144a and 144b of the base plate 140 similar to the tray NT. In the state illustrated in Fig. 13(b), the center of each placing hole 144 coincides with the center of the circular portion 150 of the corresponding loophole 154 and the above-described placing hole open state is realized. Meanwhile, in the state of Fig. 13(a), the center of each placing hole 144 approximately coincides with the center of an arc present in the tip of the slot portion 74 of the corresponding slot hole 154, and the placing hold in a closed state is realized. With such a structure, in regard to prevention of the separation of the nozzles N, a mechanism including the cover plate 142, that is, a nozzle separation preventing mechanism which is referred to as a so-called "shutter mechanism" is provided in the pallet NP. In addition, similar to the tray NT, the cover plate 142 is biased by a spring (not illustrated) so as to put the placing hole into the placing hole closed state and the placing hole is put into the placing hole open state by sliding the cover plate 142 with a force greater than the biasing force of the spring.

Similar to the tray NT, in the pallet NP, a two-dimensional code 156 is attached to one corner of the base plate 140 as an identifier for recognizing the specific information of the tray NT. The two-dimensional code 156 shows the ID of the tray NT as a kind of the specific information and the ID is used for individual management of the tray NT.

In the pallet NP, a reference nozzle 158 is fixed to one corner portion of the base plate 140 and a reference pipe 160 is fixed to the side of the reference nozzle 158, and both are in a state of passing through the base plate 140. The reference nozzle 158 is practically a nozzle N, specifically, the above-described nozzle Nb. Meanwhile, the reference pipe 160 is a part of the nozzle N, specifically, a simulated object that simulates the barrel tube 30 and the suction pipe 32 . The reference nozzle 158 and the reference pipe 160 function as reference targets to be referenced in the inspection performed by the above-described first inspecting device 106 and the second inspecting device 108 and are used for at least one of setting a reference of inspection performed by the inspecting devices 106 and 108, calibration or examination of the inspecting devices 106 and 108. Although the specific use thereof will be described below, the reference nozzle 158 is referenced in the necessary retreat force inspection using the first inspecting device 106 and the identifier reading inspection using the second inspecting device. Further, the reference pipe 160 is referenced in the tip portion state inspection using the first inspecting device 106 and in the passing flow rate inspection using the second inspecting device 108. In addition, the reference nozzle 158 and the reference pipe 160 are configured such that excellent inspection results can be generally obtained in the inspection to be referenced as reference targets. In addition, in the management machine 80, the reference target is provided in the pallet NP, but may be provided, for example, in the body of the management machine 80 or other devices in the positions in which the inspection can be performed by the first inspecting device 106 and the second inspecting device 108.

### ii) Pallet moving device

As described above, the pallet moving device 134 includes a plurality of pallet carriers 130 and the carrier circulating mechanism 132. The carrier 130 is a member which generally has a shape of a channel, that is, whose cross-section has a shape of a "U" character, and the carriers are arranged in a posture in which opening portions in the channel shape are directed to the lower side. A pair of rails 170 are attached to the lower end portion of the carrier 130, specifically, the inside of the lower end portion of two flanges in the channel shape, and the above-described pallet NP is held so as to be discharged toward the front side by the pair of rails 170 or so as to be inserted from the front side thereof.

As understood from Figs. 5 and 6, the carrier circulating mechanism 132 includes a pair of sprocket axes 172 respectively disposed in the vertical direction. The sprocket axes 172 are disposed in a state of being extended in the longitudinal direction and have sprockets 174 on each of the end portions in the longitudinal direction. A chain 176 is wound between the sprocket 174 in the front sides of the pair of sprocket axes 172 and between the sprocket 174 on the rear sides thereof. A plurality of brackets 178 are extended toward the outside at a right angle to each of the chain 176 on the front side and the chain 176 on the rear side and one carrier 130 is swingably supported by each tip of the brackets 178 on the front side and each tips corresponding to the brackets 178 on the rear side. Since one of the pair of sprocket axis 172 is a driving axis, each bracket 178 is rotated by allowing one of the pair to rotate. In this manner, each carrier 130 supported by each bracket 178 is concurrently rotated. In addition, the pallet NP is held by the carrier 130 in a posture in which the surface on which the nozzles N are placed is directed to the upper side, that is, in a posture in which the cover plate 142 is positioned on the upper side, and the supporting structure of the carrier 130 supported by the bracket 178 is configured so as to maintain the posture of the pallet NP even in a case where the carrier 130 is in any rotating position.

Since the carrier circulating mechanism 132 has the above-described structure, the pallet moving device 134 is considered as a pallet circulating device that circulates and moves a plurality of pallets NP concurrently, that is, all together, along a certain path parallel to a plane which is vertically arranged in the storing device 100. Moreover, in the moving device 134, a plurality of set positions corresponding to the above-described respective devices 104 to 108 for performing a treatment on nozzles, that is, a plurality of set positions corresponding to the first to fourth pallet transfer devices 114 to 120 are set as stop positions of each pallet NP. The set position can be considered as a station in the circulation of the pallet NP and the management machine 80 is configured such that the pallet NP moved and stopped in a specific station is transferred to the corresponding devices 104 to 108 for performing a treatment on nozzles by the first to fourth transfer devices 114 to 120 corresponding to the station. In addition, in a case where the carrier 130 not holding the pallet NP is positioned in a specific station, the pallet NP can be transferred from the corresponding devices 104 to 108 for performing a treatment on nozzles to the carrier 130 by the first to fourth transfer devices 114 to 120 corresponding to the station.

The nozzles N between the device for performing a treatment on nozzles and the nozzle storing device 100 are transferred by the nozzle transfer device corresponding to the device for performing a treatment on nozzles. Since the nozzles N are transferred in a state of being placed on the above-described pallet NP, the nozzle transfer device is used as the pallet transfer device. Specifically, the first pallet transfer device 114 that transfers a pallet between the nozzle transfer device 104 and the nozzle storing device 100; the second pallet transfer device 116 that transfers a pallet between the first nozzle inspecting device 106 and the nozzle storing device 100; the third pallet transfer device 118 that transfers a pallet between the second nozzle inspecting device 108 and the nozzle storing device 100; and the fourth pallet transfer device 120 that transfers a pallet between the nozzle washing device 110 and the nozzle storing device 100 are respectively disposed. In addition, the nozzle transfer device has a function of transferring one or more nozzles N as a one nozzle group and the nozzle transfer device 104, the first nozzle inspection device 106, the second nozzle inspection device 108, and the nozzle washing device 110, each of which is a device for performing a treatment on nozzles, perform a process on the nozzles N included in one nozzle group transferred by the nozzle transfer device as described below in detail.

### [D] Tray storing device

The tray storing device 102 is a device that stores the nozzle tray NT described above, includes a tray moving device (hereinafter, also simply referred to as a "moving device") 190 similar to the pallet moving device 134 of the nozzle storing device 100, and uses the moving device 190 as a main constituent element. The moving device 190 includes a plurality of tray carriers (hereinafter, also simply referred to as a "carrier") 192 in which the tray NT is stored similar to the pallet moving device 134 and a carrier circulating mechanism (hereinafter, also simply referred to as a "circulating mechanism") 194 that circulates the carriers 192.

The carrier 192 is a member which generally has a shape of a channel, that is, whose cross-section has a shape of a "U" character similar to the pallet carrier 130 described above, and the carriers are arranged in a posture in which opening portions in the channel shape are directed to the lower side. Similar to the pallet carrier 130, a pair of rails 196 are attached to the lower end portion of the carrier 192, specifically, the inside of the lower end portion of two flanges in the channel shape, and the tray NT is held so as to be discharged toward the front side by the pair of rails 196 in a posture in which the surface on which the nozzles N are placed is directed to the upper side or so as to be inserted from the front side thereof.

As illustrated from Figs. 5 and 6, the circulating mechanism 194 includes a pair of sprocket axes respectively having two sprockets in the vertical direction, a pair of chains, and a plurality of brackets extended to each chain and is configured so as to rotate respective carriers 192 supported by respective brackets at the same time, similar to the circulating mechanism 132 of the pallet moving device 134. The tray moving device 190 including the circulating mechanism 194 having such a structure is used as a tray circulating device that circulates and moves a plurality of pallets NP concurrently, that is, all together, along a certain path parallel to a plane which is vertically arranged in the storing device 102, similar to the pallet moving device 134 described above. Moreover, in the tray moving device 190, one set position corresponding to the above-described nozzle transfer device 104, that is, one set position corresponding to the tray transfer devices 122 is set as a stop position of each pallet NP. In a case where the tray NT, which is moved and stopped in the set position, that is, the station, is transferred to the transfer device 104 by the tray transfer device 122 and the carrier 192 not holding the tray NT is positioned in the station, the tray NT can be transferred from the transfer device 104 to the carrier 192 by the tray transfer device 122.

### [E] Nozzle transfer device

In the management machine 80, in order to set the nozzles N stored in the storing device 100 in the tray NT, the nozzles N are transferred from the pallet NP to the tray NT. Further, in order to store the nozzles N in the storing device 100, the nozzles N are transferred to the pallet NP from the tray NT. When the former is referred to as "setting transfer" and the latter is referred to as "storage transfer," the setting transfer and the storage transfer are performed by the above-described nozzle transfer device 104 positioned in the upper portion of the front side of the management machine 80.

As illustrated in Fig. 7, the drawer 82 (in the figure, in a state of slightly being pulled out) included in the management machine 80 includes a table 200 and the tray NT provided for the transfer is set one of a fixed stage 202 and a movable stage 204 provided in the table 200. The fixed stage 202 is fixed to the table 200 and the movable stage 204 is supported by the table 200 so as to be slidable in the longitudinal direction by a stage slide mechanism 206 provided in the table 200. In addition, in the figure, the fixed stage 202 and the movable stage 204 respectively illustrate a state in which the tray NT is set and a state in which the tray NT is not set. Moreover, in the figure, a state in which the movable stage 204 is positioned in a set position which is the front end in the transfer range, that is, the transfer position is illustrated. Further, for the sake of simplicity, the structure related to holding the tray NT of the stages 202 and 204 and the nozzles N placed on the tray NT are not illustrated. In addition, cover sliding mechanisms (not illustrated) that slide the cover plate 62 are respectively provided in the fixed stage 202 and the movable stage 204 as a mechanism for putting the placing the set tray NT into the placing hole open state described above.

An operator is capable of setting the tray NT and removing the set tray NT in a state in which the drawer 82 is pulled out with respect to both of the fixed stage 202 and the movable stage 204. In addition, the tray NT can be transferred between the tray storing device 102 and the movable stage 204 in a state in which the movable stage 204 is positioned in the rear end position in the moving range. Specifically, the tray NT is transferred between the carrier 192 positioned in the above-described set position, that is, the station corresponding to the transfer device and the movable stage 204 in the storing device 102. Moreover, the tray transfer mechanism which is a mechanism for transferring the tray NT is not described here. Further, the above-described tray transfer device 122 that transfers the tray NT between the set position on the table 2000 and the storing device 102, specifically, the transfer device 104 and the storing device 102 is configured by including the movable stage 204, the stage slide mechanism 206, and the tray transfer mechanism.

As understood from the description above, in the management machine 80, the setting transfer with respect to the tray NT brought from the outside and set in the fixed stage 202 or the movable stage 204 is possible and the setting transfer to the tray NT stored in the storing device 102 is also possible. Further, the tray NT in which the nozzles N are set and the tray NT which brought from the outside in a state in which the nozzles N are placed can be stored in the storing device 102.

The pallet NP provided for the setting transfer and the storage transfer is transferred from a set position corresponding to the transfer device 104 in the nozzle storing device 100, that is, the carrier 130 positioned in the station corresponding to the transfer device to a set position in which the nozzles N can be transferred by the transfer device 104, that is, a transfer position using the first pallet transfer device 114 (the structure thereof will be described below). The position in which the pallet NP is positioned in the figure is the transfer position. The pallet NP provided for the setting transfer and the storage transfer is transferred to the carrier 130 positioned in the station corresponding to the transfer device in the storing device 100 by the first transfer device 114 after the setting transfer and the storage transfer are finished. Moreover, for the sake of simplicity, the nozzles N placed on the pallet NP are not illustrated in the figure. In addition, a pallet fixing mechanism (not illustrated) that fixes the pallet NP positioned on the transfer position to the position is provided in the first transfer device 114 and a cover sliding mechanism (not illustrated) that slides the cover plate 142 is provided on the table 200 as a mechanism for putting the state of the pallet NP positioned in the transfer position into the placing hole open state.

The transfer device 104 is arranged on the upper side of the table 200 and includes a transfer head 210 and a head moving device 212 having three head moving mechanisms that move the transfer head 210 in the horizontal direction, the longitudinal direction, and the vertical direction (hereinafter, also respectively referred to as the "X direction," the "Y direction," and the "Z direction"). As understood from Figs. 5 and 6 in addition to Fig. 7, an X direction moving mechanism that moves the transfer head 210 in the X direction and a Y direction moving mechanism that moves the moving head 210 in the Y direction are not illustrated in these figures and only a Z direction moving mechanism 214 is illustrated. In addition, the X direction moving mechanism and the Y direction moving mechanism constitute an XY type moving device that is disposed in the upper portion of the body of the management machine 80 and moves the slide 216 along a plane at a right angle to the Z direction, and the Z direction moving mechanism 214 is disposed in the slide 216.

A holding chuck 218 serving as a nozzle holding jig for holding the nozzles N to be transferred and a camera 220 serving as an identifier reader for reading two-dimensional codes 38, 76, and 156 respectively provided for the nozzles N, the tray NT, and the pallet NP are attached to the lower portion of the transfer head 210. Further, the transfer head 210 includes a chuck rotating mechanism that rotates the holding chuck 218 around the axis. In addition, the above-described head moving device 212 functions as a holding jig moving device that moves the holding chuck 218 which is a nozzle holding jig.

When a basic operation of the transfer device 104 is simply described, the transfer head 210 is moved by the head moving device 212 and at least one of the two-dimensional code 76 provided for the tray NT and the two-dimensional code 156 provided for the pallet NP is imaged by the camera 220 while at least one of the setting transfer and the storage transfer is performed. Further, the transfer head 210 is moved, by the head transfer device 212, to the upper side of the pallet NP or the tray NT which becomes a transfer source, the two-dimensional code 38 of the nozzles N serving as the target of transfer is imaged by the camera 220, the nozzles N are held by the holding chuck 218, and the transfer 210 is moved, by the head moving device 212, to the upper side of the tray NT or the pallet NP which becomes a transfer destination, and the held nozzles N are separated from the holding chuck 218 and then placed on specific or optional placing holes 64 and 144 of the tray NT or the pallet NP.

Moreover, a placing plate 220 such that the base plate 140 of the pallet NP, specifically, a placing plate 222 having several placing holds is disposed on the table 200, and the placing plate 222 is used for temporary placing of the nozzles N while the nozzles N are set in the tray NT or the nozzles N are stored in the storing device 100. A defective box 224 is detachably disposed on the table 200 as a defective nozzle indwelling device that indwells nozzles N determined as defectives, that is, defective nozzles based on the results of the inspection on various items. As understood from the figures, the defective box 224 is partitioned into four spaces 226 and each of the four spaces 226 is respectively used as an indwelling unit that distinguishes defective nozzles from other nozzles and indwells the defective nozzles. Although the use of the defective box 224 will be described below, the transportation of the defective nozzles to the defective box 224 is performed by the nozzle transfer device 104 after setting the nozzles N in the tray NT or regardless of the setting. Accordingly, the transfer device 104 functions as a defective nozzle transporting device.

### [F] First nozzle inspecting device

The first nozzle inspection device 106 is a device that is positioned on the lower side of the nozzle transfer device 104 and performs inspection on two items, specifically, tip portion state inspection and necessary retreat force inspection as described above. When described with reference to Fig. 8, after the pallet NP positioned in the set position in the above-described storing device 100, that is, the station corresponding to the first inspection device is transferred to the inspection position by the above-described second pallet transfer device 116 (the structure thereof will be described below), the tip portion state inspection and the necessary retreat force inspection of the nozzles N placed on the pallet NP are performed by the first inspection device 106 from the lower side of the nozzles N. Further, the position of the pallet NP illustrated in the figure is the above-described inspection position and a pallet fixing mechanism (not illustrated) that fixes the pallet NP to the inspection position is provided in the second transfer device 116. In addition, for the sake of simplicity, the nozzles N placed on the pallet NP is not illustrated in the figure.

The first inspecting device 106 includes a base 230, an inspecting unit 235 having a camera device 232 and a load measuring device 234 fixed on the base 230, and a unit moving device 236 moving the inspecting unit 235, and the inspection unit 235 moves the space on the lower side of the pallet NP positioned in the inspection position. The camera device 232 includes a camera main body 238, a lens 239, a ringlight 240 that is positioned so as to surround the lens 239 as a light source, and the load measuring device 234 uses a load cell 242 as a main constituent element. The unit moving device 236 includes a movable beam 246 that is supported by a pair of beams 244 that form a part of the body of the management machine 80; a Y direction moving mechanism 248 having a belt driving system that moves the movable beam 246 in the Y direction; an X direction moving mechanism 252 that moves a slide 250 supported by the movable beam 264 in the X direction; and a Z direction moving mechanism 254 that fixes to the slide 250, supports the inspection unit 235 in the base 230, and moves the inspection unit 235 in the Z direction. In summary, according to the first inspecting device 106, the tip portion state inspection and the necessary retreat force inspection are both performed on the tip portion side of the nozzles N, and the camera device 232 and the load measuring device 234 which are main constituent elements for performing inspection on various items are arranged in the space present on the tip portion side of the nozzles N and those are moved by the unit moving device 236 which is a kind of moving device.

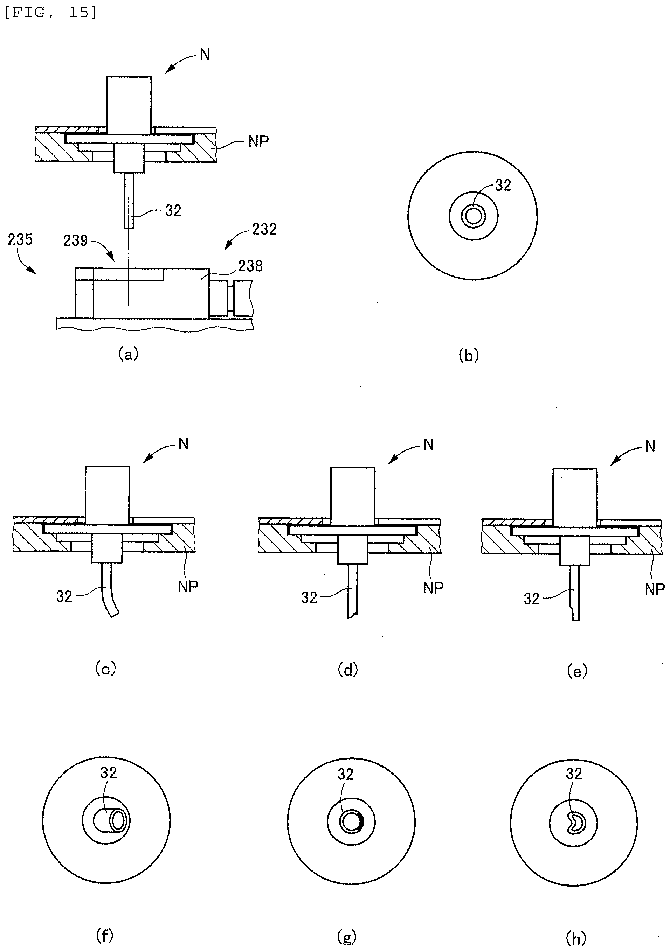

In the tip portion state inspection performed by the first inspection device 106, as illustrated in Fig. 15 (a), the inspecting unit 235 is moved to a position by the unit moving device 236, which is positioned directly below the nozzles N inspected by the lens 239 of the camera device 232. Specifically, the position of the suction pipe 32 of the nozzles N in the Z direction can be recognized from the specific information of the nozzles N, the inspecting unit 235 is positioned in the position in which the lens 239 is separated from the tip of the suction pipe 32 by a set distance. In this state, the tip portion of the nozzle N, that is, the suction pipe 32 is imaged by the camera device 232.

The nozzle N illustrated in Fig. 15 (a) is a nozzle N whose shape of the suction pipe 32 is normal and Fig. 15(b) illustrates an image captured by the camera device 232 of the suction pipe 32 of the nozzle N. Further, Figs. 15(c) to 15(e) respectively illustrate a nozzle N with "curvature, " "chipping of the tip," and "crushing of the tip" of the suction pipe 32, and the captured images of the suction pipes 32 of the nozzle N are illustrated in Figs. 5(f) to 5(g). In the tip portion state inspection, it is confirmed whether the shape abnormality of the tip portion such as the "curvature," the "chipping of the tip, " or the "crushing of the tip" is generated in a nozzle N based on the image data of the nozzles N captured by the camera device 232. Further, although not illustrated, "attachment of foreign matters" or "attachment of dirt" to the tip portion is confirmed as well. A nozzle N in which shape abnormality is generated in the tip portion and a nozzle N in which a foreign matter or dirt is attached to the tip portion is determined as a defective nozzle. In addition, although the description will be made below in detail, the tip portion of the reference pipe 160 fixed to the pallet NP is imaged by the camera device 232 whenever abnormality on the state of the tip portion of any nozzle N is confirmed, and a nozzle N in which abnormality is confirmed in the state of the tip portion is certified as a defective nozzle under the condition in which abnormality is not found in the tip portion of the reference pipe 160 after confirmation whether abnormality is generated based on image data of the tip portion of the reference pipe 160. That is, the reference pipe 160 as a reference target is used for examination of the first inspecting device 106, specifically, for post-examination.

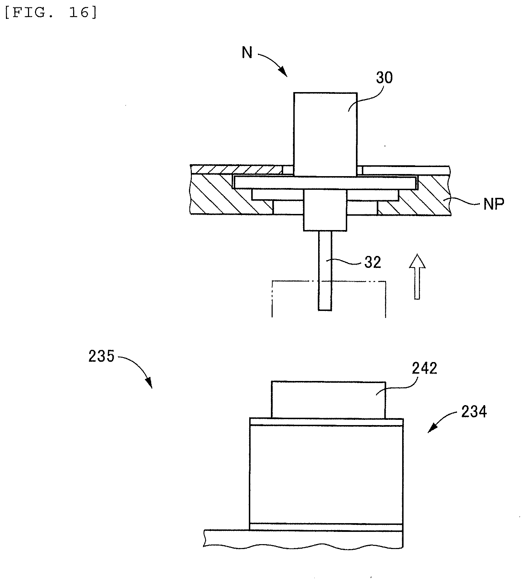

In the necessary retreat force inspection performed by the first inspection device 106, as illustrated in Fig. 16, the inspecting unit 235 is moved to a position, by the unit moving device 236, positioned directly below the nozzle N to be inspected by the center of the load cell 242 of the load measuring device 234. In this position, the inspecting unit 235 is lifted by the set distance based on the specific information of the nozzles N. Specifically, the load measuring device 234 is lifted to a position in which the suction pipe 32 of the nozzles N retreats by a certain distance with respect to the barrel tube 30.

As described above, the suction pipe 32 is biased to the advancing direction from the barrel tube 30 by a spring, and the tip of the suction pipe 32 is brought into contact with the upper surface of the load cell 242 in the case where the load measuring device 234 is lifted, and a load corresponding to the biasing force of the spring is applied to the load cell 242 in this state. The load cell 242 measures the load. The biasing force due to the spring can be recognized from the specific information of the nozzles N and the necessary retreat force of the suction pipe 32 is excessive in a case where a load greater than the biasing force is detected by the load cell 242. For example, the suction pipe 32 is not easily drawn into the barrel tube 30 due to the mixture of foreign matters into the nozzles N or damage of the barrel tube 30, and the necessary retreat force becomes excessive in this case. In a case where the necessary retreat force is greater than the threshold force set based on the specific information, the necessary retreat force is certified as excessive and the nozzle N is determined as a defective nozzle. Moreover, in a case where the necessary retreat force inspection of the nozzles N being placed on one pallet NP is performed, the load applied to the above-described reference nozzle 158 is measured prior to the inspection, and calibration of the load cell 242, that is, adjustment for making the load value measured by the load cell 242 become equivalent to the actual value is performed based on the measured load . That is, the reference nozzle 158 as the reference target is used for calibration of the load measuring device 234 performed as a preliminary process of the necessary retreat force inspection performed by the first inspecting device 106, in other words, calibration of the first inspecting device 106.

Moreover, the tip portion state inspection and the necessary retreat force inspection performed by the first inspection device 106 may be performed on all nozzles N being placed on one pallet NP or on some nozzles N. In addition, both inspections may be performed or only one of them may be performed. After the inspection on the placed nozzles N is finished, the pallet NP positioned in the inspection position is transferred to the carrier 130, by the second transfer device 116, positioned in the station corresponding to the first inspecting device in the storing device 100.

### [G] Second nozzle inspecting device

As described above, the second nozzle inspection device 108 is a device that is positioned on the lower side of the first nozzle inspection device 106 and performs inspection on two items, specifically, passing flow rate inspection and identifier reading inspection. When described with reference to Fig. 9, after the pallet NP positioned in the set position in the above-described storing device 100, that is, the station corresponding to the second inspection device is transferred to the inspection position by the above-described third pallet transfer device 118 (the structure thereof will be described below), the passing flow rate inspection and the identifier reading inspection of the nozzles N placed on the pallet NP are performed by the second inspection device 108 from the upper side of the nozzles N. Further, the position of the pallet NP illustrated in the figure is the above-described inspection position and a pallet fixing mechanism (not illustrated) that fixes the pallet NP to the inspection position is provided in the third transfer device 118. In addition, for the sake of simplicity, the nozzles N placed on the pallet NP is not illustrated in the figure.

The second inspection device 108 includes an inspection head 270 and a head moving device 272 that moves the inspection head 270 along a plane parallel to the upper surface of the pallet NP on the upper side of the pallet NP. An air carrying device 274 and a camera 276 as an identifier reader are provided in the inspection head 270 parallel to each other. The air carrying device 274 includes an air joint 278 that is connected to the upper end portion of the barrel tube 30 which is the based end portion of the nozzle N and compressed air is supplied to the nozzle N from the air joint 278. The air pressure sensor 280 that measures the air pressure of a supply path of the compressed air to be supplied is disposed on the upper side of the air joint 278 integrally with the air joint 278. In addition, the air carrying device 274 includes a joint elevating mechanism 282 that elevates the air joint 278 and the air joint 278 is elevated by the joint elevating mechanism 282 with respect to the inspection head 270. The head moving device 272 includes a movable beam 284 that is supported by a pair of beams 244 that is described related to the first inspecting device 106; a Y direction moving mechanism 286 having a belt driving system that moves the movable beam 284 in the Y direction; and an X direction moving mechanism 290 that moves a slide 288 supported by the movable beam 284 in the X direction. In summary, according to the second inspecting device 108, the passing flow rate inspection and the identifier reading inspection are both performed on the base end portion side of the nozzles N, and the air carrying device 274 and the camera 276 which are main constituent elements for performing inspection on various items are arranged in the space present on the base end portion side of the nozzles N and those are moved by the head moving device 272 which is a kind of moving device.

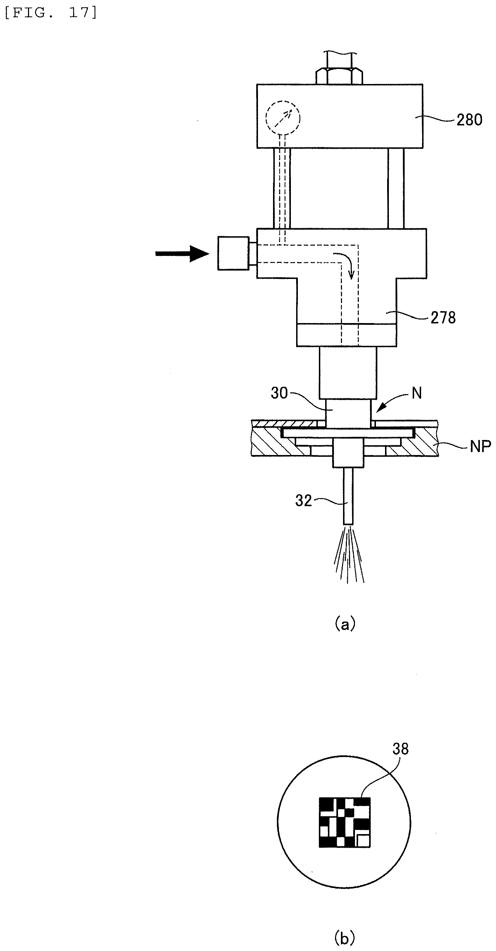

In the passing flow rate inspection performed by the second inspection device 108, the inspection head 270 is moved to a position, by the head moving device 272, in which the air joint 278 is positioned on the right above the nozzle to be inspected. In this state, the air joint 278 is lowered so as to be connected with the nozzle N by the joint elevating mechanism 282. As illustrated in Fig. 17(a), in a state in which the air joint 278 is connected to the nozzle N, the air carrying device 274 carries the compressed air to the nozzle N. In a normal nozzle N, the air which is not so resistive is allowed to pass through, a flow rate is sufficiently secured, and the air pressure to be measured by the air pressure sensor 280 becomes relative small. Meanwhile, for example, in a case where "clogging" is generated in the nozzle N, passing resistance to the air passing through the nozzle N becomes large and thus the flow rate is not sufficiently secured. In this state, the air pressure to be measured by the air pressure sensor 280 becomes relatively high. In consideration of this point, in a case where the air pressure measured by the air pressure sensor 280 is larger than the threshold pressure in the passing flow rate inspection, generation of the "clogging" in the nozzle N is certified and the nozzle N is determined as a defective nozzle. That is, in the passing flow rate inspection, the "clogging" of the nozzle N is certified by measuring the pressure of the nozzle N on the base end portion side instead of directly measuring the flow rate of the air. Moreover, the flow meter (flow sensor) is disposed in place of the air pressure sensor 280, the flow rate of the air passing through the flow meter is directly measured, and the presence of "clogging" may be determined based on the result of the measurement.

Further, the compressed air carried to the nozzle N is supplied to the air carrying device 274 from a compressor (not illustrated) disposed in the above-described driving source unit 124, but the air pressure is measured by the air pressure sensor 280 to change, for example, depending on the output pressure of the compressor. That is, the air pressure is changed by the environmental conditions related to the second inspection device 108. In consideration of this point, it is preferable to set the threshold pressure according to the environmental conditions. In the management machine 80, the compressed air is carried to the reference pipe 160 fixed to the pallet NP by the air carrying device 274 and the threshold pressure is set based on the air pressure to be measured by the air pressure sensor 280 prior to the passing flow rate inspection of the nozzle N. That is, the reference pipe 160 as the reference target is used for setting a reference of the inspection to be performed as a preliminary process related to the passing flow rate inspection performed by the second inspecting device 108.

In the identifier reading inspection performed by the second inspecting device 108, the inspection head 270 is moved to a position, by the head moving device 272, in which the camera 276 is positioned in the right above the two-dimensional code 38 which is an identifier provided for the flange 34 of the nozzle N to be inspected. In this state, the two-dimensional code 38 is imaged by the camera 276. In addition, an image captured by the camera 276 is, for example, a view of Fig. 17 (b) . In the identifier reading inspection, the ID of the nozzle N is recognized based on the image data obtained by capturing an image by the camera and the nozzle N is determined as a defective nozzle in a case where the ID cannot be recognized. In the management machine 80, since the ID cannot be recognized due to the malfunction of the camera 276 or the like, the two-dimensional code 38 attached to the flange 34 of the reference nozzle 158 fixed to the pallet NP is imaged by the camera 276 prior to the reading of the two-dimensional code 38 of the nozzle N, the function of reading an identifier of the second inspecting device 108 is confirmed to be sufficient based on the image data obtained by capturing an image by the camera, and the identifier reading inspection of the nozzle N is performed under the condition in which the function of reading an identifier is sufficient. That is, the reference nozzle 158 as a reference target is used for examination of the second inspecting device 108, that is, for post-examination.

Moreover, the passing flow rate inspection and the identifier reading inspection performed by the second inspection device 108 may be performed on all nozzles N being placed on one pallet NP or on some nozzles N. In addition, both inspections may be performed or only one of them may be performed. After the inspection on the placed nozzles N is finished, the pallet NP positioned in the inspection position is transferred to the carrier 130, by the second transfer device 116, positioned in the station corresponding to the second inspecting device in the storing device 100.

### [H] Nozzle washing device and nozzle drying device

The nozzle washing device 110 is positioned on the lower side of the second nozzle inspecting device 108 and the nozzle drying device 112 is positioned between the washing device 110 and the above-described storing device 100. A housing 300 is provided in the management machine 80 in relation to the washing device 110 and the drying device 112. Fig. 10 illustrates the washing device 110 and the drying device 112 in the presence of the housing 300 is present and Fig. 11 illustrates the washing device 110 and the drying device 112 without the housing 300. When the description is made with reference to those figures, after the pallet NP positioned in the set position in the storing device 100, that is, the station corresponding to the washing device is transferred to a washing position by the above-described fourth pallet transfer device 120 (the structure thereof will be described below), the nozzles N placed on the pallet NP in the position are washed by the washing device 110. Further, after washing, the washed nozzles N which are placed on the pallet NP are dried by the drying device 112 during the transfer of the pallet NP to the station corresponding to the washing device by the fourth pallet transfer device 120. The position of the pallet NP illustrated in the figure is the above-described washing position, and a pallet fixing mechanism (not illustrated) that fixes the pallet NP in the inspection position is provided in the fourth transfer device 120. In addition, for the sake of simplicity, the nozzles N placed on the pallet NP is not illustrated in the figure.

The washing device 110 includes an upper portion washing unit 302 that washes the nozzle N from the upper portion thereof and a lower portion washing unit 304 that washes the nozzle N from the lower portion thereof, and the upper portion washing unit 302 and the lower portion washing unit 304 have approximately the same structure. Each of the units 302 and 304 includes a support frame 306 attached to the housing 300; an injection nozzle 308 supported by the support frame 306; and a Y direction moving mechanism 310 moving the injection nozzle 308 in the Y direction. The injection nozzle 308 has a shape of a long and narrow rectangle positioned so as to extend in the X direction over the entire width of the pallet NP, and multiple injection holes 312 are provided on the surface facing the pallet NP. The Y direction moving mechanism 310 moves the injection nozzle 308 in the Y direction over the entire length of the pallet NP. High-pressure water pressed by a high-pressure pump (not illustrated) which is disposed in the above-described driving source unit 124 is supplied to the injection nozzle 308 and the high-pressure water is injected toward the nozzles N placed on the pallet NP from the injection hole 312.

The drying device 112 includes a plurality of air blowing pipes 314 disposed in the upper portion and the lower portion of the housing 300. Warm air (hot air) is sent to the air blowing pipes 314 through a heater (not illustrated) disposed in the driving source unit 124 from a blower (not illustrated) . A plurality of releasing holes are provided in each of the plurality of air blowing pipes 314 and the warm air is released toward the nozzles N placed on the pallet NP from the releasing holes. The nozzles N are dried by the released warm air.

The above-described housing 300 is disposed to prevent the high-pressure water injected by the washing device 110 and the warm air released by the drying device 112 from adversely affecting other devices. A transparent window 316 for peeking the inside is provided on the front side of the housing 300, and a shielding plate 318 and a shielding plate opening and closing mechanism 320 which is opened only when the pallet NP passes through the shielding plate 318 are provided on the rear side thereof.

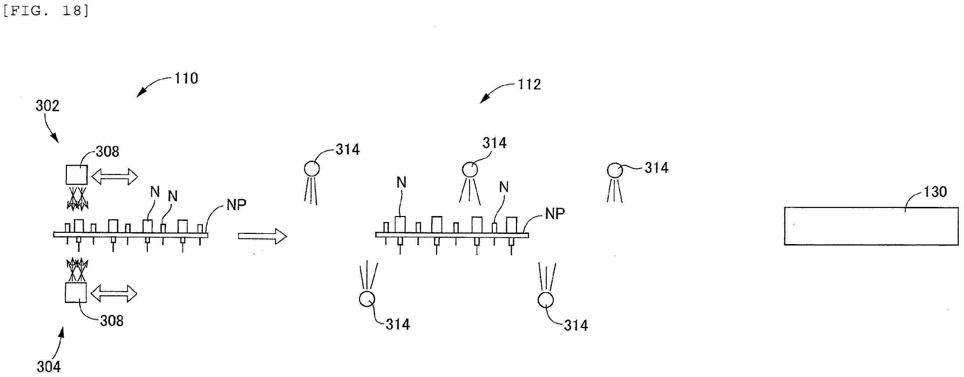

As illustrated in Fig. 18, the nozzles N being placed on the pallet NP fixed in the above-described washing position is washed by the washing device 110. Specifically, the upper portion washing unit 302 injects high-pressure water from the upper side of the nozzle N, that is, the base end side of the nozzle N and mainly washes the upper surface or the like of the barrel tube 30 and the flange 34. Meanwhile, the lower portion washing unit 304 injects high-pressure water from the lower side of the nozzle N, that is, the tip side of the nozzle N and mainly washes the suction pipe 32. In order to obtain a high washing effect, the orientation of the injection hole 312 is adjusted such that the injection nozzle 308 injects high-pressure water to various directions in addition to the direction of directly below or directly above . Since the width of the injection nozzle 308 is relatively narrow and the high-pressure water is only injected to some of the nozzle arrays arranged on the pallet NP in the X direction, the injection nozzle 308 is moved, by the Y direction moving mechanism 310, across the entire length of the pallet NP in the Y direction. In addition, the injection nozzle 308 is a nozzle having a two-fluid system, that is, not a nozzle injecting water by distributing water using the compressed air but a nozzle configured so as to inject water pressed by a pump using the pressure of the water from the injection hole 312 directly. Therefore, the washing device 110 is considered as a device with high washing ability.

The drying device 112 performs drying by blowing warm air when the fourth transfer device 120 transfers the pallet NP present in the inspection position after the nozzles N are washed to the station 130 corresponding to a washing device. Accordingly, during at least a part of the time necessary for drying, the pallet NP can be returned to the storing device 100 and thus the time loss in a series of processes such as washing and drying is reduced. In addition, warm air has a relatively high speed and water droplets adhered to the nozzles N are blown off by the pressure of the warm air and the water remaining on the nozzles N is dried by the temperature of the warm air.

### [I] Pallet transfer device

The first to fourth pallet transfer devices 114 to 120, each of which is a nozzle transfer device, are devices that transfer the pallet NP between the storing device 100 and the device for performing a treatment on nozzles as described above. The first, second, and third transfer devices 114, 116, and 118 have approximately the same structure and the fourth transfer device 120 has a structure slightly different from those of the first, second, and third transfer devices 114, 116, and 118.

When the description is made with reference to Figs. 5 to 7, each of the first, second, and third transfer devices 114, 116, and 118 includes a pair of rails 330 disposed so as to be extended toward the front side from the storing device 100 and the pallet NP is supported by the pair of rails 330 so as to straddle over the pair of rails 330 and slide thereon. Further, each of the first, second, and third transfer devices 114, 116, and 118 includes the moving mechanism 332 that moves the pallet NP between the carrier 130 of the storing device 100 and the pair of rails 330 and on the pair of rails 330. The moving mechanism 332 includes a guide 334 disposed so as to be extended in the longitudinal direction on the right side of the management machine 80 and a transporting unit 336 supported by the guide 334. The transporting unit 336 self-travels along the guide 334 in a state of being supported by the guide 334. Although not illustrated, the transporting unit 336 includes an extending portion that extends to the intermediate portion of the pair of rails 330 on the lower side of the pair of rails 330 and a clamp that grips the rear end portion of the pallet NP from the lower side thereof is provided in the tip of the extending portion.

When one carrier 130 of the storing device 100 is positioned in the above-described set position, that is, the station corresponding to the device for performing a treatment on nozzles, a pair of rails 330 and a pair of rails 170 of the carrier 13 coincide with each other and the transporting unit 336 can be moved to the rear end of the guide 334 such that the extending portion passes through the lower side of the carrier 130. The above-described clamp grips the rear end portion of the pallet NP stored in the carrier 130 in a state in which the transporting unit 336 is positioned in the rear end and the pallet NP is transferred to the above-described setting position by the transporting unit 336 moves to the front end of the guide 334 in the state of the pallet NP being gripped. After the transfer, the state of the pallet NP being gripped by the clamp is released. In a case where the pallet NP positioned in the set position is transferred to the carrier 130, a reverse operation of the above-described operation is performed. In addition, the set position means the above-described transfer position, inspection position, or washing position. Further, as described above, each of the first, second, and third transfer devices 114, 116, and 118 includes the pallet fixing mechanism for fixing the pallet NP positioned in the set position to the pair of rails.

The structures of the guide and the transporting unit of the fourth transfer device 120 are different from those of the first, second, and third transfer devices 114, 116, and 118. Although detailed description thereof is not made here, since the fourth transfer device 120 transfers the pallet NP in the housing 300 as described above, the guide 338 and the transporting unit 340 having structures suitable for the transfer are employed. The structures and operations of other portions of the fourth transfer device 120 are the same as those of the first, second, and third transfer devices 114, 116, and 118 and thus the description thereof will not be repeated. In addition, in Fig. 5, the illustration is made such that each of the first, second, and third transfer devices 114, 116, and 118 includes two transporting units 336, but the reason for this is to conveniently illustrate both of the state in which the transporting unit 336 is positioned in the front end of the guide and the state in which the transporting unit 336 is positioned in the rear end thereof, and practically, each of the first, second, and third transfer devices 114, 116, and 118 includes only one transporting unit 336.

### [J] Operation performed by nozzle management machine

The management machine 80 performs various operations by the control of the controller 84 which is a control device. Specifically, the controller 84 performs an operation according to an executed program by executing various programs . In addition, the operations are performed based on the management information, that is, information related to the nozzles N and the tray NT to be created or acquired while managing the stored nozzles N and the tray NT. Hereinafter, after the management information is described, several operations performed by the management machine 80 are exemplified and sequentially described.

### i) Management information

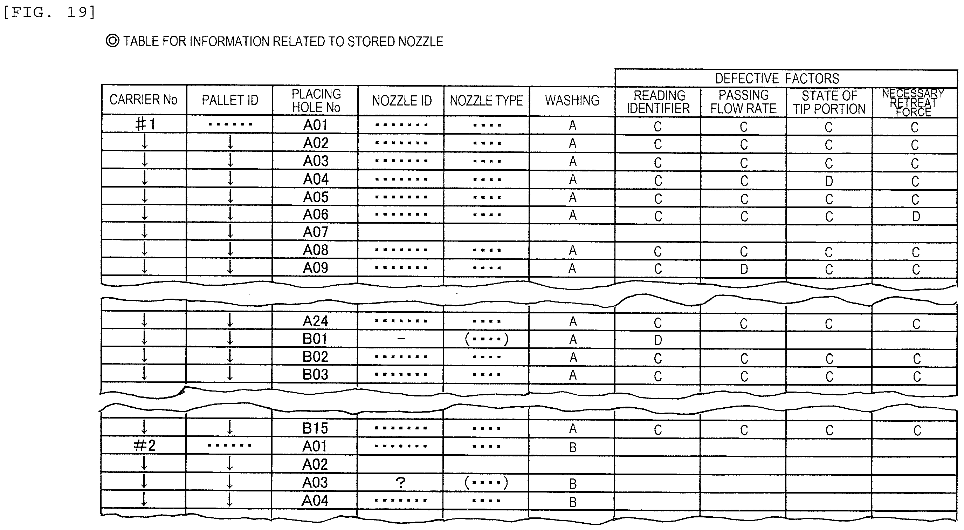

The controller 84 stores "information related to stored nozzle" as management information related on stored nozzles N. The information related to stored nozzle can be schematically illustrated as a table for information related to stored nozzle of Fig. 19. When simply described, the stored nozzle information is information showing that which nozzles N are stored in which placing hole 144 of which pallet NP stored in which carrier 130. In other words, the stored nozzle information is information in a mode in which the specific information of the stored nozzles N are associated with a storage position in the storing device 100. In the description below, the information related to stored nozzle is handled as information stored in a form of the above-described table and the information related to stored nozzle will be described in detail based on the table.

In the table for information related to stored nozzle illustrated in the figure, each row corresponds to one placing hole 144 of one pallet NP, that is, each of the stored nozzles N. In addition, each column of the table corresponds to various pieces of information related to the nozzles N. Specifically, the "carrier No" indicates the number of the carriers 130 storing the pallet NP on which the nozzles N are placed and the numbers of the carriers 130 included in the storing device 100 are stored in a form of "#1," "#2," .... The "pallet ID" indicates an ID of the pallet NP as the specific information of the pallet NP on which the nozzles N are placed. The "placing hole No" indicates the number of the placing holes 144 serving as placing units on which the nozzles N are placed and the numbers of "A01" to "A24" are stored in correspondence with small placing holes 144a illustrated in Fig. 12 and the numbers of "B01" to "B15" are stored in correspondence with large placing holes 144b. In addition, the arrows "↓" in the "carrier No" and the "pallet ID," conveniently indicate that the contents which are the same as those in the upper row are stored.

The "nozzle ID" and the columns on the right side thereof are all related to specific information of the nozzles N. When description is made on each item, the "nozzle ID" indicates the ID of the nozzle N. When "-" is shown in the "nozzle ID," this means that the ID of the nozzle N cannot be recognized. Further, when "?" is shown in the "nozzle ID," this means that the ID of the nozzle N has not been recognized yet. The "nozzle type" shows the types of nozzles N, that is, the kinds of nozzles N. Specifically, the types of respective nozzles Na to Ne illustrated in Fig. 13 are stored. The "(••••)" means that the type of a nozzle is assumed. The "washing" indicates whether the nozzles N are washed by the washing device 110, "A" indicates that the nozzles are washed, and "B" indicates that the nozzles have not been washed yet.

The "defective factor" indicates a factor of a defective in a case where a nozzle N is determined as a defective nozzle, that is, the nozzle N determined as a defective nozzle in any of the inspections on the above-described four items. In the case where the nozzle N is determined as a defective nozzle in any of the inspections on four items, "D" is stored in a column corresponding to the item determined as a defective nozzle from among four columns of "reading identifier," "passing flow rate," "state of tip portion," and "necessary retreat force." "C" indicates that a nozzle is not determined as a defective nozzle in the inspections on respective items, and in a case where "C" or "D" is not stored in each column, this means that the inspections have not been performed yet.

In addition, rows without any description in the columns of the "nozzle ID" to "washing" indicate that placing holes 144 corresponding to the rows, that is, the placing holes 144 of the pallet NP stored in a carrier 130 do not have nozzles N being placed thereon.

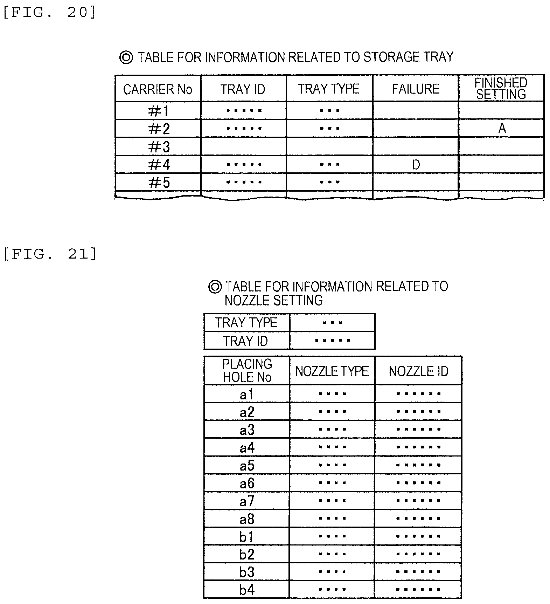

The controller 84 stores the "information related to stored tray" as the management information related to the stored tray NT. The information related to the stored tray can be schematically illustrated as a table for information related to the stored tray in Fig. 20. When simply described, the stored tray information is information indicating that which tray N is stored in which carrier 192. In other words, the stored tray information is information in which the specific information of the stored tray NT is associated with the storage position in the storing device 102 similar to the information related to stored nozzle. In the description below, the information related to the stored tray is handled as information stored in a form of the above-described table similar to the information related to stored nozzle and the information related to the stored tray will be described in detail based on the table.

In the table for information related to the stored tray illustrated in the figure, each row corresponds to one carrier 192 of the storing device 102, that is, each of the stored tray NT. In addition, each column of the table corresponds to various pieces of information related to the tray NT. Specifically, the "carrier No" indicates the number of the carriers 192 storing the tray NT and the numbers of the carriers 192 included in the storing device 102 are stored in a form of "#1," "#2," .... The "tray ID" is an ID of the tray NT as one piece of the specific information of the tray NT. The "tray type" indicates the type of tray NT, that is, the kind of tray NT. The "defective" indicates whether the tray NT is a defective and "D" means the tray is a defective tray. The "finished setting" indicates whether nozzles N are set in the stored tray NT, "A" indicates that the nozzles N are set in the tray NT, and the blanks indicate that the tray NT is empty. In addition, the rows without any description in the columns of the "tray ID" and the "tray type" indicate that the tray NT is not stored in the carriers 192 corresponding to the rows.

In addition, the controller 84 uses the "information related to setting of nozzles" as the management information related to the setting of the nozzles N in the tray NT. The information related to setting of nozzles is schematically shown in a table for information related to setting of nozzles in Fig. 21. When simply described, the nozzle setting information is information indicating that which nozzle N is placed on which placing hole 64 of which tray NT. The "placing hole No" indicates the number of a placing hole 64 as a placing unit on which the nozzles N are placed and the figure illustrates information related to the tray NT of Fig. 3 as an example. Specifically, the numbers of "a1" to "a8" are denoted in correspondence with relatively small placing holes 64 illustrated in Fig. 3 and the numbers of "b1" to "b4" are denoted in correspondence with relatively large placing holes 64.

The setting of the nozzles N in the pallet NP is started based on the information related to setting of nozzles in which the "tray ID" and the "nozzle ID" are not described, that is, only the "tray type" and "nozzle type" are described, and the "tray ID" and the "nozzle ID" are provided at the time point at which the setting is finished.

The above-described management information is updated and reset in several operations performed by the management machine 80 described below. In the description below, the operations will be described based on the flowcharts of programs related to the operations, but the notations of processes related to the update, deletion, and addition are omitted in the flowcharts and those processes will be described in steps of the flowcharts.

### ii) Nozzle storing operation

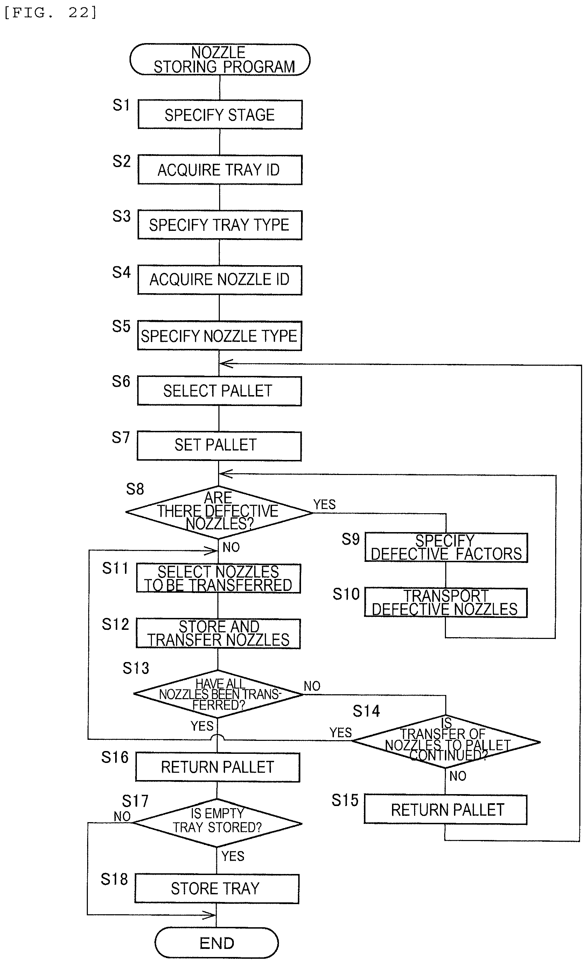

The nozzle storing operation is an operation for storing the nozzles N being placed on the tray NT in the storing device 100 for the purpose of washing, inspecting, and storing the nozzles N used in the mounting machine and the operation is performed by the controller 84 executing the nozzle storing program illustrated in the flowchart of Fig. 22. The operator of the management machine 80 opens the above-described drawer 82 and sets the tray NT on which nozzles N are placed in the fixed stage 204 or the movable stage 204, and an instruction of starting the operation is input by the operation key 88 of the controller 84 so that the operation is started. In addition, in a case where the tray NT is set in the fixed stage 202, the operation is finished in a state in which the tray NT remains after the nozzles N are stored. Meanwhile, in a case where the movable stage 204 is set on the tray NT, whether the tray NT is stored in the storing device 102 after the nozzles N are stored can be selected based on an input operation using the operation key 88 of an operator. According to the selection, the operation is finished.

In a process according to the nozzle storing program, it is specified that a stage to which the tray NT is fixed and in which the placing hole open state is realized, that is, a stage on which the tray NT is set is the fixed stage 202 or the movable stage 204 in Step 1 (hereinafter, Step is abbreviated as "S"). Next, in S2, the transfer head 210 is moved to the upper side of the specified stage, the two-dimensional code 76 attached to the tray NT is imaged by the camera 220, and the ID of the tray NT is acquired. In S3, the type of the tray NT is specified based on the ID of the acquired tray NT. In addition, the ID information includes information of the type of a tray NT. The controller 84 stores data in which the number of placing holes 64 of the tray NT, the position thereof, and the like are associated with the type of the tray (hereinafter, also referred to as "tray specification data"), the two-dimensional code 38 of each nozzle N being placed on the tray NT is imaged by the camera 220 according to the specification of the tray NT grasped based on the type thereof in S4 after the type is specified, and the ID of each nozzle N is acquired. In S5, the type of each nozzle N is specified based on the acquired ID. Similar to the tray NT, the ID information of the nozzle N includes information of the type of nozzle N. In addition, in a case where the ID of the nozzle NT cannot be acquired due to dirt or the like of a two-dimensional mark 38, the above-described information related to setting of nozzles created previously, that is, information related to setting of nozzles at the time when the nozzle N are set in the tray NT having the ID is used and the type of the nozzle N whose ID cannot be acquired is assumed.

Next, in S6, one pallet NP on which the nozzles N are placed when the nozzles N are accommodated in the nozzle storing device 100 is selected from among a plurality of pallets NP included in the nozzle storing device 100 based on the aforementioned information related to stored nozzle. Although a detailed description of an algorithm for the selection is omitted, in S6, the one pallet NP is selected based on such a viewpoint that the one pallet NP enables the management machine 80 to most efficiently perform some operations, from among the pallets NP that meets a condition that there are empty placing holes 144, a condition that nozzles N after completion of washing are not placed thereon, and the like. In subsequent S7, the pallet moving device 134 and the first pallet transfer device 114 are operated, the selected pallet NP is fixed to the aforementioned transfer position, and the placing hole open state is realized. That is, the pallet NP is set.

After the pallet NP is set, a defective nozzle is treated prior to placing the nozzle N on the pallet NP from the tray NT. More specifically, it is confirmed in S8 whether or not there is a defective nozzle in the set pallet NP based on the information related to stored nozzle. If there is a defective nozzle, the aforementioned defective factor of one defective nozzle is specified based on the information related to stored nozzle in S9, and the defective nozzle is transported to the defective box 224 by the nozzle transfer device 104 in S10. The nozzle box 224 is provided with four sectioned spaces 226 so as to correspond to the four defective factors as described above, and the defective nozzle is kept in a one of the spaces 226 corresponding to the specified defective factor when the defective nozzle is transported. Then, when the transport is completed, information relating to the defective nozzle is deleted from the information related to stored nozzle. In addition, there is considered to be a case in which two or more defective factors are present for a single defective nozzle. However, the defective nozzle is kept in the space 226 corresponding to the defective factor in the leftmost column in the table shown in Fig. 19 in such a case. The processing from S8 to S10 is repeated until there becomes no defective nozzle in the set pallet NP. If there becomes no defective nozzle or if no defective nozzle is originally present since the setting is made, the next S11 is executed.

In S11, one nozzle N which can be transferred to the set pallet NP is selected in accordance with a set rule from among the nozzles N placed on the set tray NT. In S12, the selected nozzle N is transferred to one of the empty placing holes 144 in the set pallet NP by the transfer device 104. That is, the aforementioned storing and transferring are performed. The placing hole 144 on which the selected nozzle N is to be placed is determined in accordance with a set rule based on the aforementioned information related to stored nozzle and the size of the nozzle to be placed, for example. When the one nozzle N is stored and transferred, the ID of the nozzle N acquired in S4 and the type of the nozzle specified in S5 are stored as the information related to stored nozzle. That is, the information related to stored nozzle is updated. Specifically, the ID and the Type are written, along with the fact that the nozzle N has not yet been washed, in one of rows in the table shown in Fig. 19, namely a row corresponding to the placing hole 144 on which the nozzle N is placed.

After the one nozzle N is stored and transferred, it is determined in S13 whether or not the storing and the transferring of all the nozzles N that have been placed on the set tray NT has been completed. If the storing and the transferring of all the nozzles N have not been completed, it is determined in S14 whether to continue the transferring of the nozzles N to the set pallet NP. If it is possible to continue the transferring of the nozzles N to the pallet NP, the processing returns to S11, and the next nozzle N is transferred to the pallet NP. If it is determined in S14 that the transferring to the pallet NP cannot be continued for a reason that there is no empty placing hole 144, for example, the pallet NP is returned to the storing device 100 by the first transfer device 114 in S15, and the processing returns to S6 in which the next pallet NP is selected. After the pallet NP is set, and a defective nozzle placed on the pallet NP is treated, the storing and the transferring of the nozzle N to the pallet NP are started. If it is determined in S13 that the storing and the transferring of all the nozzles N placed on the set tray NT have been completed, the set pallet NP is returned to the storing device 100 by the first transfer device 114 in S16.

After the storing and the transferring of all the nozzles N are completed, and the pallet NP is returned, it is determined in S17 whether to store the tray NT, which has become empty, in the tray storing device 102. The determination is made based on which of the fixed stage 202 and the movable stage 204 the tray NT is set on, as described above. If it is determined that the tray NT is to be stored in the storing device 102, the set empty tray NT is stored in the storing device 102 by the tray transfer device 122 in S18, and the nozzle storing operation is completed. In contrast, if it is determined in S17 that the empty tray NT is not to be stored in the storing device 102, setting of the tray NT is released, and the nozzle storing operation is completed. Prior to the storing and the transferring of the nozzles NT, the 2D code 76 provided to the tray NT is imaged by the camera 22 provided in the transfer device 104, and the ID of the tray NT is acquired. When the tray NT is stored in the storing device 102, the ID of the tray NT and the type of the tray NT, which is specified based on the ID, are added to the aforementioned information related to the stored tray in association with the storing carrier 192.

### ii) Nozzle Setting Operation

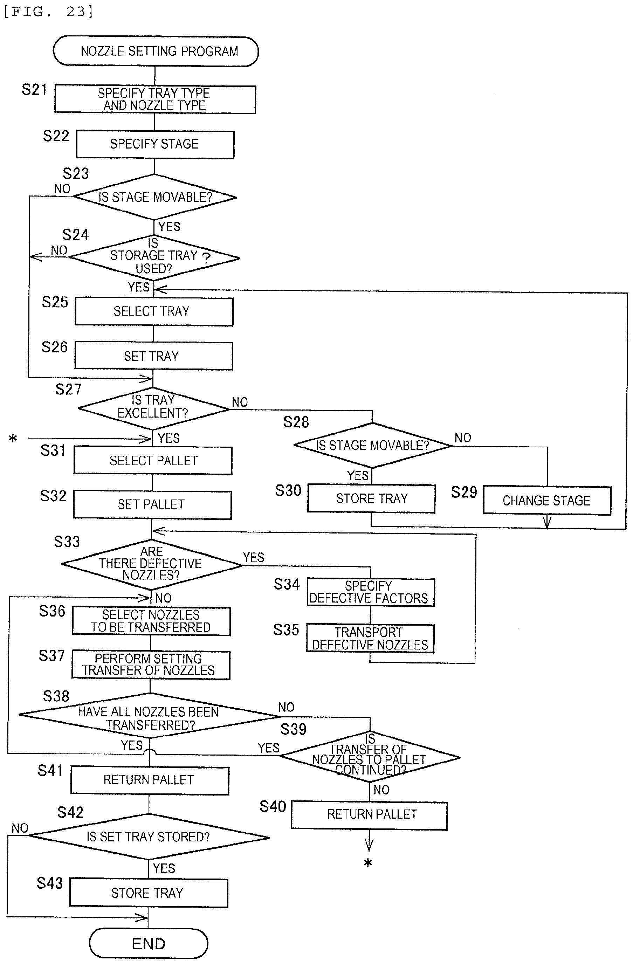

A nozzle setting operation is an operation for setting necessary nozzles N in the tray NT for the purpose of preparing for usage of the nozzles N in the mounting machine, and the operation is performed by the controller 84 executing the nozzle setting program shown in the flowchart in Fig. 23. In the nozzle setting operation it is possible to select which of the fixed stage 202 and the movable stage 204 the stage, on which the nozzles N are to be set, is to be set to, which of the tray NT stored in the storing device 102 and the tray NT set by the operator of the management machine 80 is to be used, and whether or not the tray NT after the setting is to be stored in the storing device 102. Such selection is made based on a user's operation using the operation key 88 in the controller 84.

In the processing in accordance with the nozzle setting program, the type of the tray NT as the target of the setting and the types of the respective nozzles N are specified first based on the information related to setting of nozzles sent or input to the management machine 80 or the information related to setting of nozzles which has already been stored in S21. The information related to setting of nozzles can be considered as information, the "tray ID" and the "nozzle ID" which have not been written in the table shown in Fig. 21.

Next, one of the fixed stage 202 and the movable stage 204 is specified as the stage as the target of the setting in S22. If it is determined in S23 that the movable stage 204 is the specified stage, it is determined in S24 whether to use the tray NT stored in the storage device 102. If it is determined that the tray NT stored in the storage device 102 is to be used, one tray NT is selected based on the aforementioned information related to setting of nozzles and the aforementioned information related to the stored tray in S25, and the selected tray NT is transferred to and set at the placing position by the tray transfer device 122 in S26. In contrast, if it is determined in S23 that the tray NT set by the operator is to be used, or if it is determined in S22 that setting is to be performed on the movable stage 202, the tray NT has already been set by the operator, and therefore, selection and setting of the tray NT are not performed.

Next, it is determined in S27 whether or not the set tray NT is non-defective. The camera 220 provided in the transfer device 104 is used to image the 2D code 76 attached to the set tray NT and acquire the ID of the tray NT. At this time, if the ID cannot be acquired, then it is determined that there is some defect in the tray NT. In addition, in the set tray NT, the aforementioned cover sliding mechanism is driven so as to realize the placing hole open state. At this time, if the operation of the cover sliding mechanism is not smooth, then it is determined that there is some defect in the tray NT.

In the processing in accordance with the nozzle setting program, when the defect is generated in the set tray NT, processing of replacing the set tray NT with some defect with a non-defective tray NT is performed. If it is determined first in S27 that there is some defect in the set tray NT in the tray replacement processing, it is determined in S28 which of the fixed stage 202 and the movable stage 24 the tray NT is being set on. If it is determined that the tray NT is being set on the fixed stage 202, stage changing processing is performed in S29 while the tray NT is left on the fixed stage 202 in order to inhibit usage of the tray NT. That is, processing of changing the stage, which is to be used for setting of the nozzles N, from the fixed stage 202 to the movable stage 204 is performed. In contrast, if it is determined that the tray NT is being set on the movable stage 204, the tray NT is returned by the transfer device 122 and is then stored in the storing device 102 in S30. At this time, the ID and the type of the tray NT are associated with the carrier 192, in which the tray NT is to be stored, along with the fact that the tray NT is a defective tray, and information is added to the aforementioned information related to the stored tray, or the information related to the stored tray is updated. After the stage is changed or the tray NT is stored, the processing returns to S25 in which another tray NT is selected based on the information related to setting of nozzles and the information related to the stored tray, and the selected another tray NT is set in S26. If it is determined in S27 that the set tray NT is non-defective, the acquired ID of the tray NT is added to the information related to setting of nozzles.

In the state in which the non-defective tray NT is set on the stage, a pallet NP to be used for the setting and the transferring is selected from among the plurality of pallet NP included in the storing device 100 based on the information related to setting of nozzles and the aforementioned information related to stored nozzle in S31. Although a detailed description of an algorithm for the selection is omitted, the one pallet NP is selected in S31 based on such a viewpoint that the one pallet NP is able to most efficiently perform the setting of the nozzles N, from among the pallets NP that meets a condition that one or more nozzles N to be set and transferred are placed thereon, a condition that inspection of all items of all the nozzles N placed thereon has been completed, and the like. Then, in the subsequent S32, the selected pallet NP is transferred by the first transfer device 114 and is set on the aforementioned transfer position.

After the pallet NP is set, the same treatment on the defective nozzle as that in the aforementioned nozzle storing operation is executed in S33 to S35 prior to the placing of the nozzles N on the tray NT from the pallet NP. Since the treatment was described above in detail, the description will not be repeated here. If there becomes no defective nozzle after S34 and S35 are executed, or if no defective nozzle is originally present in the pallet since the setting is made in the pallet NP, the next S36 is executed.

In S36, one nozzle that can be placed on the set tray NT is selected from among the nozzles N placed on the set pallet NP based on the information related to stored nozzle and the information related to setting of nozzles. In subsequent S37, the selected nozzle N is transferred to a specific placing hole 64 in the set tray NT based on the information related to setting of nozzles. That is, the aforementioned setting and transferring are performed. In the setting and the transferring, information relating to the transferred nozzle N is deleted from the information related to stored nozzle, and the ID of the nozzle is added to the information related to setting of nozzles. In the setting and the transferring, processing of causing the camera 220 that is provided in the transfer device 104 to acquire the ID of the transferred nozzle N and confirming that the acquired ID is not different from the ID stored as the information related to stored nozzle may be performed. Alternatively, the acquired ID may be added to the information related to setting of nozzles without performing the confirmation processing.

After the one nozzle N is set and transferred, it is determined in S38 whether or not the setting and the transferring of all the scheduled nozzles N have been completed. If the setting and the transferring of all the nozzles N have not been completed, it is determined in S39 whether to continue the transferring of the nozzles N from the set pallet NP. If it is possible to continue the transferring of the nozzles N from the pallet NP, the processing returns to S36, in which the next nozzle N is transferred from the pallet NP to the next tray NT. If it is determined in S39 that the transferring from the pallet NP cannot be continued due to a reason that no nozzle N that can be transferred is present on the pallet NP, for example, the pallet NP is returned to the storing device 100 by the first transfer device 114 in S40, and the processing returns to S31, in which the next pallet NP is selected. After the pallet NP is set and the defective nozzle placed on the pallet NP is treated, the setting and the transferring of the nozzles N from the pallet NP are started. If it is determined in S39 that the setting and the transferring of all the scheduled nozzles N have been completed, the set pallet NP is returned to the storing device 100 by the first transfer device 114 in S41.

After the setting and the transferring of all the nozzles N are completed and the pallet NP is returned, it is determined in S42 whether to store the tray NT, on which the nozzles N are being set, in the tray storing device 102. If it is determined that the tray NT is to be stored in the storing device 102, the set tray NT is stored in the storing device 102 by the tray transfer device 122 in S43, and the nozzle storing operation is completed. In contrast, if it is determined in S42 that the tray NT is not to be stored in the storing device 102, the setting of the tray NT is released, and the nozzle storing operation is completed while the tray NT is left on the fixed stage 102 or the movable stage 204. Prior to the setting and the transferring of the nozzles NT, the 2D code 76 attached to the tray NT is imaged by the camera 22 provided in the transfer device 104, and the ID of the tray NT is acquired. When the tray NT is stored in the storing device 102, the ID of the tray NT is added to the aforementioned information related to the stored tray in association with the carrier 192, in which the tray NT is to be stored, along with the fact that the tray NT is a tray NT for which the setting of the nozzles N has been completed. In contrast, if the operation is completed while the tray NT, on which setting of the nozzles has been completed, is left on the movable stage 204, the information relating to the tray NT included in the information related to the stored tray is deleted.

### iv) Nozzle Resetting Operation

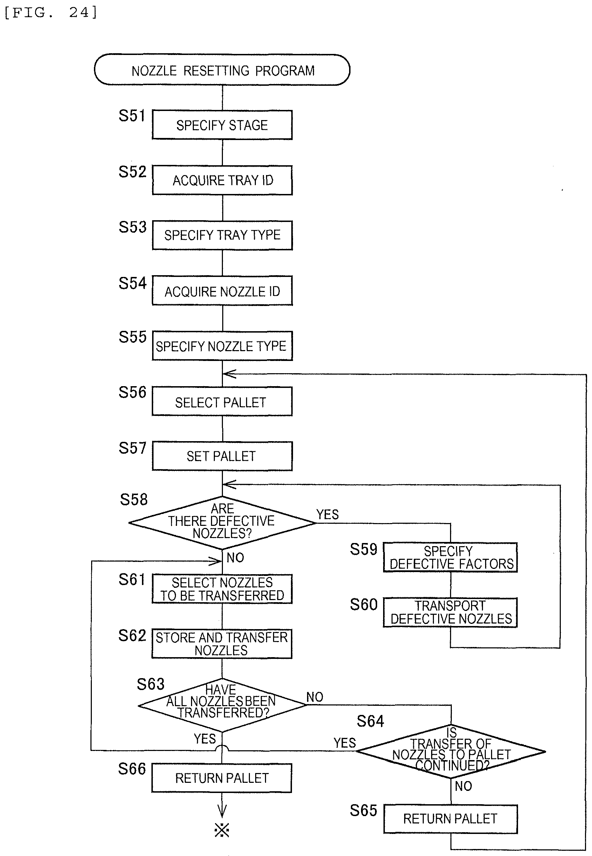

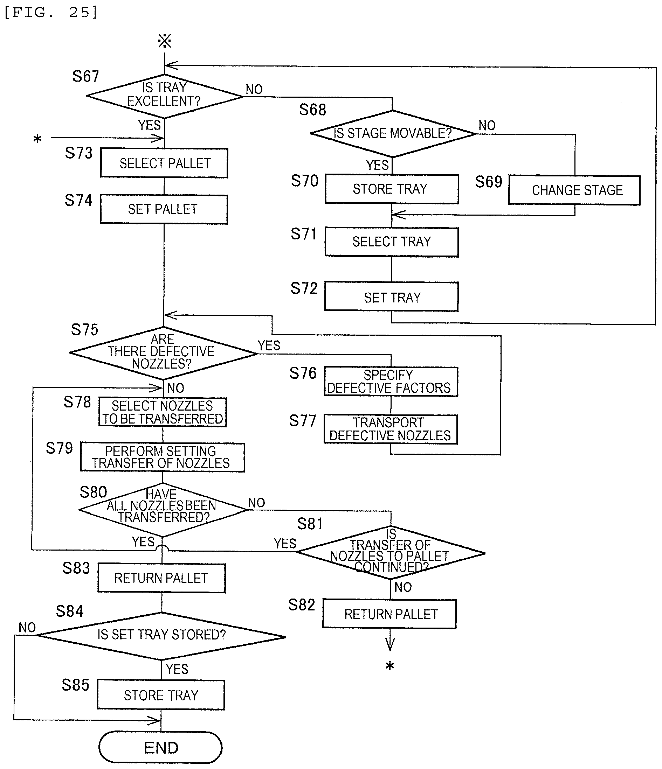

Nozzle resetting operation is an operation of setting a tray NT, on which nozzles N have already been set, on a stage to place other nozzles of the same type as the set nozzles N instead of the set nozzles N. In other words, the resetting operation is an operation of creating the information related to setting of nozzles based on the tray NT, on which the nozzles N have already been set, and replacing the nozzles based on the created information. The nozzle setting operation is performed by the controller 84 executing the nozzle resetting program shown in the flowcharts in Figs. 24 and 25. In the nozzle setting operation, it is possible to select one of the fixed stage 202 and the movable stage 204 as a stage on which the nozzles N are to be set and to select whether or not the tray NT after the resetting is to be stored in the storage device 102. The selection is made based on an operator's operation using the operation key 88 in the controller 84.

In short, a nozzle storing operation is performed in the first half of the nozzle resetting operation. Specifically, the nozzles N placed on the set tray NT are stored in the storing device 100 by processing in accordance with the first half portion of the nozzle resetting operation shown in the flowchart in Fig. 24. Since processing in S51 to S66 of the program is substantially the same as the processing in S1 to S16 of the aforementioned nozzle storing program, the description of the processing will be omitted. The information related to setting of nozzles is created based on the type of the tray NT and the type of the nozzles N that are specified in S53 and S55. Even in the nozzle resetting operation, the defective nozzle is treated in S58 to S60.

After the nozzles NT placed on the tray NT are stored in the storage device 100, other nozzles N stored in the storage device 100 are set on the tray NT, on which the nozzles N have been placed till then, in principle by the processing in accordance with the second half portion of the nozzle resetting program shown in the flowchart in Fig. 25. Since the processing performed in the flow from S67 to S85 of the program is substantially the same as the processing performed in the flow from S27 to S43 of the aforementioned nozzle setting program, the description of the processing will be omitted. In the nozzle resetting operation, the defective nozzle is treated even in S75 to S77. In this operation, the aforementioned processing for replacing the tray NT is executed even in S67 to S72.

### v) Nozzle washing operation

The nozzle washing operation is an operation of washing and drying nozzles N being placed on one pallet NP in the storing device 100 with the entire pallet NP. Since the details of washing and drying of nozzles N will be described below, the flow of the operation will be mainly described here. Further, three operations of this operation, the first nozzle inspecting operation and the second nozzle inspecting operation described below are all performed independently from all other operations described in examples. That is, regardless of the fact that whether other operation is performed, all of three operations can be performed on nozzles N being placed on the pallet NP other than pallets NP which are targets of other operations as long as the set conditions are satisfied.

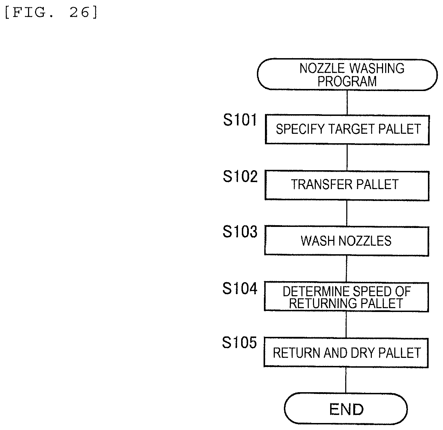

The nozzle washing operation is performed by executing the nozzle washing program illustrated in the flowchart of Fig. 26. In the process according to the program, first, the pallet NP as a target of the operation is specified in S101. Specifically, one of pallets NP satisfying the condition in which unwashed nozzles N are placed more than the set number of nozzles is determined as a target pallet in consideration of the efficiency of the operation and another operation. Next, the pallet NP is transferred to the above-described washing position by the fourth pallet washing device 118 in S102. In addition, in S103, nozzles N being placed on the pallet NP are washed by the nozzle washing device 110 with the entire pallet NP in a state in which the pallet NP is positioned in the position.

After the washing of the nozzles N by the washing device 110 is finished, the speed of returning the pallet NP by the fourth pallet transfer device 118 is determined in S104. As described above, the nozzles N being placed on the pallet NP are dried in the middle of returning of the pallet NP by the fourth transfer device 118. Accordingly, in S104, the speed of returning is determined based on the environmental temperature, the temperature of the warm air, and the like in order to secure the time necessary for sufficiently drying the nozzles N. After the speed is determined, in S105, the pallet NP is returned at the determined returning speed and the nozzles N being placed on the pallet NP are dried by the nozzle drying device 112 with the entire pallet NP. In addition, after the nozzles N are dried, the above-described information related to stored nozzle related to the washed nozzles N is updated. Specifically, in the table illustrated in Fig. 19, a symbol "A" indicating that nozzles are washed is provided and updating for the purpose of handing the nozzles as nozzles in which all inspections are not finished is carried out in regard to all nozzles N being placed on the pallet NP.

### vi) First nozzle inspecting operation

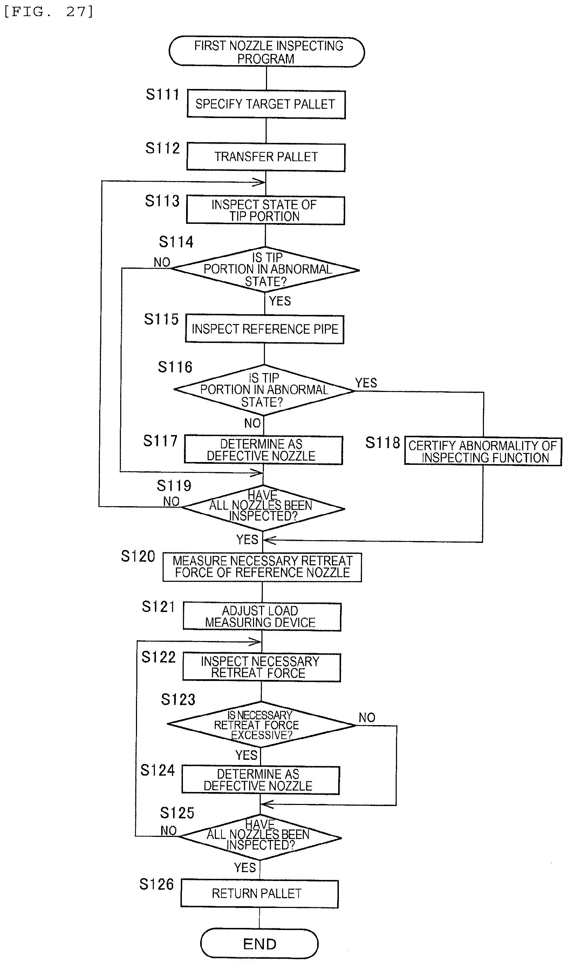

The first nozzle inspection operation is an operation of performing the tip portion state inspection and the necessary retreat force inspection on the nozzles N being placed on one pallet NP in the storing device 100 using the first inspecting device 106 and is performed by executing the first nozzle inspecting program illustrated in the flowchart in Fig. 27. In addition, since the tip portion state inspection and the necessary retreat force inspection have been described above in detail, the flow of the operation will be mainly described here.

In the process according to the first nozzle inspecting program, first, the pallet NP as a target of the operation is specified in Sill. Specifically, one pallet NP satisfying the condition in which all nozzles N being placed are washed or the like is determined as a target pallet in consideration of the operation and another operation. Next, the pallet NP is transferred to the above-described inspection position by the second pallet transfer device 116 in S112 after the target pallet is determined.

The tip portion state inspection is performed in preference to the necessary retreat force inspection on respective nozzles N being placed on the pallet NP transferred to the inspection position. The tip portion state inspection is sequentially performed on each of the nozzles N. First, the tip portion state inspection is performed on one nozzle N in S113. Specifically, as described above, the lens 239 of the camera device 232 is moved to a position positioned right below the one nozzle N by the unit moving device 236 and the tip portion of the nozzle N is imaged by the camera device 232, and it is confirmed that whether the state of the tip portion is abnormal based on image data obtained by capturing an image. Specifically, it is confirmed that whether the shape abnormality of the tip portion such as "curvature, " "chipping of the tip, " or "crushing of the tip" and "attachment of foreign matters or dirt" are generated on the nozzle N. Based on the result of the confirmation, determination is made in S114 and the tip portion state inspection is performed on the above-described reference pipe 160 fixed to the pallet NP in a case where it is recognized that the state of the tip portion is abnormal in S115. Specifically, the tip portion of the reference pipe 160 is imaged by the camera device 232 and it is confirmed that whether abnormality is found in the state of the tip portion of the reference pipe 160 based on the image data of the tip portion obtained by capturing an image. As a result of the confirmation, determination is made in S116 and it is determined that the nozzle N is a defective nozzle in S117 in a case where the state of the tip portion of the reference pipe 160 is normal. Meanwhile, in the case where the state of the tip portion of the reference pipe 160 is abnormal, it is certified that the function related to the inspection of the first inspecting device 106 is abnormal in S118, the certification is displayed on the display 86, the abnormality of the state of the tip portion with respect to the nozzle N is not determined, and the tip portion state inspection subsequently performed on other nozzles N is skipped. In S114, in a case where it is confirmed that the state of the tip portion is normal or it is determined that the nozzle N is a defective nozzle in S117, processes subsequent to S113 are repeated until the tip portion state inspection is completed on all nozzles N being placed on the pallet NP by performing the process of S119.

As a result of the above-described series of processes, "C" is provided for the column of the "state of the tip portion" of the nozzle N in the information related to stored nozzle illustrated in Fig. 19 in the case where it is determined that the state of the tip portion of the nozzle N is normal and "D" is provided in the case where the nozzle N is determined as a defective nozzle in terms of the state of the tip portion. In the case where it is certified that the function of inspection using the first inspecting device 106 is abnormal, the columns of the "the state of the tip portion" of all nozzles N being placed on the pallet NP are blanked. That is, the nozzles N being placed on the pallet NP are considered as nozzles, all of which are not subjected to the tip portion state inspection.

After the tip portion state inspection, the necessary retreat force inspection is sequentially performed on each of the nozzles N being placed on the pallet NP. In a process according to the program, prior to the necessary retreat force inspection with respect to each nozzle N, in S120, the necessary retreat force of the above-described reference nozzle 158 which is fixed to the pallet NP is measured. That is, when the suction pipe 32 of the reference nozzle 158 is allowed to retreat, the load applied to the load cell 242 included in the load measuring device 234 is measured. Next, in S121, the load measuring device 234 is adjusted (for example, setting or the like of the lifted distance of the load measuring device 234 performed by the unit moving device 236) for the purpose of the value of the load measured by the load cell 242 becoming equivalent to the actual value based on the measurement results.

After the above-described adjustment of the load measuring device 234, first, the necessary retreat force inspection is performed on one nozzle N in S122. Specifically, the load cell 242 is positioned on the lower side of the nozzle N to be measured, the load measuring device 234 is lifted by the set distance, and the load applied to the load cell 242 at this time is measured. In addition, in a case where the load is greater than the threshold force set for the nozzle N, it is certified that the necessary retreat force of the nozzle N is excessive. Based on the certification, determination is made in S123, and the nozzle N is determined as a defective nozzle in S124 in the case where the necessary retreat force is excessive. Further, processes subsequent to S122 are repeated until the necessary retreat force inspection performed on all nozzles N being placed on the pallet NP is completed by a process of S125.

As a result of the above-described series of processes, "C" is provided for the column of the "necessary retreat force" of the nozzle N in the information related to stored nozzle illustrated in Fig. 19 in the case where it is determined that the necessary retreat force of the nozzle N is normal and "D" is provided in the case where the nozzle N is determined as a defective nozzle in terms of the necessary retreat force. After the necessary retreat force inspection of all nozzles N being placed on the pallet NP is finished, the pallet NP is returned to the storing device 100 by the second transfer device 116 in S126.

### vii) Second nozzle inspecting operation

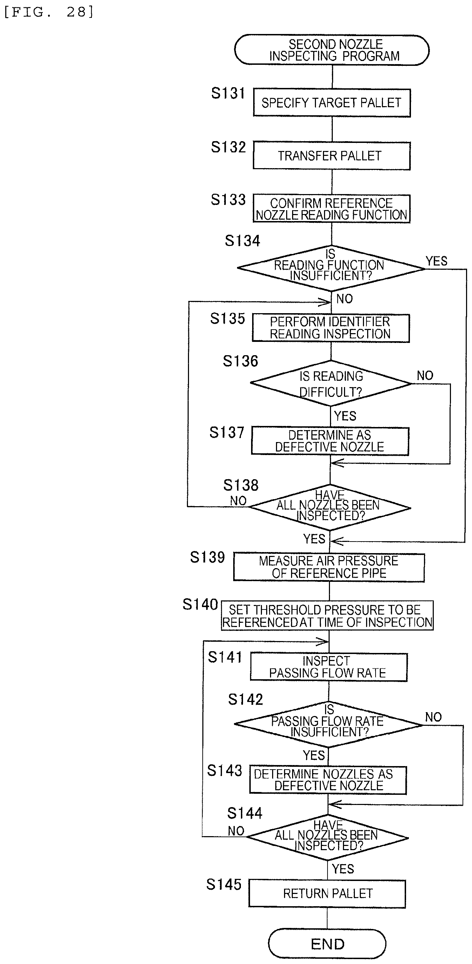

The second nozzle inspecting operation is an operation of performing identifier reading inspection and passing flow rate inspection using the second inspecting device 108 with respect to nozzles N being placed on one pallet NP in the storing device 100 and is performed by executing the second nozzle inspecting program illustrated in the flowchart of Fig. 28. Since the details of the identifier reading inspection and the passing flow rate inspection have been described above, the flow of the operation will be mainly described here.

In the process according to the second nozzle inspecting program, first, a pallet NP as a target of the operation is specified in S131. Specifically, one pallet NP satisfying the condition in which all nozzles N being placed are washed or the like is determined as a target pallet in consideration of the operation and another operation. Next, the pallet NP is transferred to the inspection position by the third pallet transfer device 118 in S132 after the target pallet is determined.

The identifier reading inspection is performed in preference to the passing flow rate inspection with respect to each of the nozzles N being placed on the pallet NP transferred to the inspection position. The identifier reading inspection is sequentially performed on each of the nozzles N by the camera 276 included in the second inspecting device 108, but the two-dimensional code 38 provided for the flange 34 of the reference nozzle 158 which is fixed to the pallet NP is imaged by the camera 276 prior to the inspection of each nozzle N in S133 and it is confirmed that the function related to the identifier reading inspection of the second inspecting device 100 is sufficient based on the image data obtained by capturing an image. In addition, determination is made in S134 based on the result of the confirmation and the identifier reading inspection is performed on each of the nozzles N in S135 and subsequent steps under the condition in which the above-described function is sufficient. Further, in a case where it is confirm the function related to the identifier reading inspection is insufficient in the determination of S134, the content of confirmation is displayed on the display 86 and the identifier reading inspection is not performed on each of the nozzles N being placed on the pallet NP.

In the identifier reading inspection performed on one nozzle N in S135, first, the inspection head 270 is moved to a position, by the head moving device 272, in which the camera 276 is positioned in the right above the two-dimensional code 38 provided for the flange 34 of the nozzle N, and the two-dimensional code 38 is captured by the camera 276. In addition, it is confirmed that whether the ID of the nozzle N can be sufficiently recognized based on the image data obtained by capturing an image. In addition, it is confirmed that whether the ID of the nozzle N can be sufficiently recognized based on the image data obtained by capturing an image. The determination is made in S136 based on the result of the confirmation and it is determined that the nozzle N is a defective nozzle in S137 in a case where the ID cannot be sufficiently read from the image two-dimensional code 38, that is, it is difficult to read the two-dimensional code 38. In addition, processes subsequent to the process of S135 are repeated until the identifier reading inspection performed on all nozzles N being placed on the pallet NP is completed by the process of S138.

As a result of the above-described series of processes, "C" is provided for the column of the "reading identifier" of the nozzle N in the information related to stored nozzle illustrated in Fig. 19 in the case where the two-dimensional code 38 can be sufficiently read, that is, the nozzle N is normal in terms of reading an identifier and "D" is provided for the column in the case where the nozzle N is determined as a defective nozzle in terms of reading an identifier. In the case where it is certified that the function of inspection using the second inspecting device 108 is insufficient and the identifier reading inspection is not performed on each nozzle N, the columns of the "reading identifier" of all nozzles N being placed on the pallet P are blanked so as to include the fact in the information related to stored nozzle. In addition, in a case where the two-dimensional code 38 cannot be read in the storing and transferring of the nozzles N and in a case where it is determined that the ID of the nozzle N in which "?" is provided for the column of the "nozzle ID" and " (••••)" is provided for the column of the "nozzle type," can be sufficiently recognized by the identifier reading inspection, and the ID read during the inspection is written in the column of the "nozzle ID" and the nozzle type specified based on the ID is written in the column of the "nozzle type."

After the identifier reading inspection, the passing flow rate inspection is sequentially performed on each of the nozzles N being placed on the pallet NP. However, in the process according to the program, the compressed air is supplied to the above-described reference pipe 160, by the air carrying device 274, which fixed to the pallet NP in S139 prior to the passing flow rate inspection of respective nozzles N, the air pressure is measured by the air pressure sensor 280 in this state. Next, the above-described threshold pressure to be referenced at the time of passing flow rate inspection of the nozzles N is set based on the measured air pressure in S140.

After the threshold pressure is set, first, the passing flow rate inspection is performed on one nozzle N in S141. Specifically, the compressed air is supplied to the nozzle N, to be inspected, by the air carrying device 274 and the air pressure is measured by the air pressure sensor 280 in this state. In addition, in a case where the measured air pressure is higher than the set threshold value, it is certified that the passing flow rate of the air of the nozzle N is insufficient. Based on the result of the certification, in a case where determination is made in S142 and the passing flow rate is insufficient, the nozzle N is determined as a defective nozzle in S143. In addition, processes subsequent to the process of S141 are repeated until the passing flow rate inspection performed on all nozzles N being placed on the pallet NP is completed by carrying out the process of S144.

As a result of the above-described series of processes, "C" is provided for the column of the "amount of passing flow rate" of the nozzle N in the information related to stored nozzle illustrated in Fig. 19 in the case where it is determined that the amount of the passing flow rate of the nozzle N is normal and "D" is provided in the case where the nozzle N is determined as a defective nozzle in terms of the passing flow rate. After the passing flow rate inspection of all nozzles N being placed on the pallet NP is finished, the pallet NP is returned to the storing device 100 by the third transfer device 118 in S145.

### [K] Functional configuration of control device

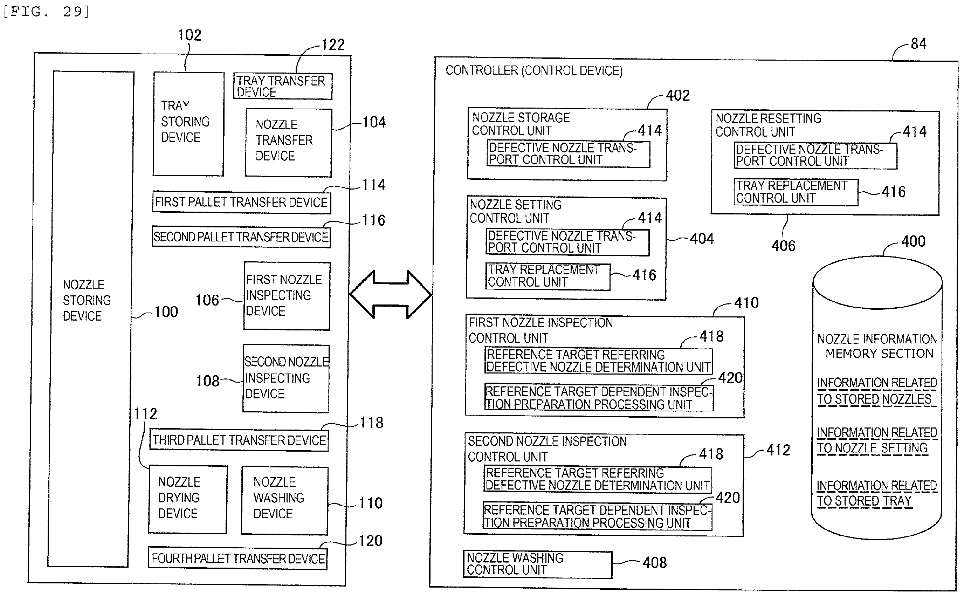

As described above, the management machine 80 of Examples is controlled by the controller 84 which is a control device. Specifically, as illustrated in Fig. 29, respective operations of the nozzle storing device 100 to the tray transfer device 122 are controlled by the controller 84 by exchanging signals and information therebetween. In addition, under the control of the controller 84, the management machine 80 performs the above-described various operations. In consideration of the operations, the controller 84 can be considered to include a plurality of functional units as illustrated in Fig. 29, that is, a plurality of functional units realized by executing various programs.

When each of a plurality of functional units are specifically described, the controller 84 includes a nozzle information memory section 400 as a functional unit storing the above-described information related to stored nozzle, information related to setting of nozzles, and information related to the stored tray which are management information respectively related to nozzles N. Specifically, a storage medium such as a hard disk included in a computer which is a main constituent element of the controller 84 plays a role of the nozzle information memory section 400. In addition, the management machine 80 performs the above-described operations based on the stored management information.

Further, the controller 84 includes six functional units as the functional units controlling the above-described respective operations. Specifically, the controller 84 includes a nozzle storage control unit 402 that controls the nozzle storing operation, a nozzle setting control unit 404 that controls the nozzle setting operation, a nozzle resetting control unit 406 that controls the nozzle resetting operation, a nozzle washing control unit 408 that controls the nozzle washing operation, a first nozzle inspection control unit 410 that controls the first nozzle inspecting operation, and a second nozzle inspection control unit 412 that controls the second nozzle inspecting operation. In addition, these control unit 402 to 412 are functional units realized by executing the above-described nozzle storing program, the nozzle setting program, the nozzle resetting program, the nozzle washing program, the first nozzle inspecting program, and the second nozzle inspecting program.

Furthermore, the nozzle storage control unit 402, the nozzle setting control unit 404, and the nozzle resetting control unit 406 will be described in detail. Each of the control units 404, 406, and 408 includes a defective nozzle transport control unit 414 as a functional unit for controlling the treatment of the defective nozzle that is placed on the pallet NP, that is the treatment of transporting the defective nozzle in order to keep the defective nozzle in the corresponding space 226 sectioned in the defective box 224 in accordance with the inspected item regarding of which the defective nozzle has been determined to be defective. The defective nozzle transport control unit 414 is a functional unit that is realized by execution of any of S8 to S10, S33 to S35, S58 to S60, and S75 to S77. In addition, each of the nozzle setting control unit 404 and the nozzle resetting control unit 406 includes a tray replacement control unit 416 as a functional unit for controlling the tray transfer device 122 when it is determined that there is some defect in the tray NT to replace the tray NT with another tray NT being stored in the tray storing device 102. The tray replacement control unit 416 is a functional unit that is realized by execution of either S27 to S30 and the following S25 and S26, or S67 to S72.

Furthermore, the first nozzle inspection control unit 410 and the second nozzle inspection control unit 412 will be described in detail. Each of the control units 410 and 412 includes a reference target referring defective nozzle determination unit 418 as a functional unit which determines that a nozzle N is a defective nozzle based on a condition that the nozzle is determined to be defective as results of inspection by nozzle inspection devices 106 and 108 and a reference nozzle 158 or a reference pipe 160 as a reference is determined to be non-defective as a result of inspection. The reference target referring defective nozzle determination unit 418 is a functional unit that is realized by execution of either S114 to S117 or S134 to S138. In addition, each of the control units 410 and 412 includes a reference target dependent inspection preparation processing unit 420 as a functional unit that performs, as preparation processing, setting of the reference for the inspection by the nozzle inspection devices 106 and 108 or correction of the nozzle inspection devices 106 and 108 by using the reference nozzle 158 or the reference pipe 160 as a reference, prior to the inspection of the nozzles N. The reference target dependent inspection preparation processing unit 420 is a functional unit that is realized by execution of either S120 and S121 or S139 and S140.

### Reference Signs List

10: Electrical component mounting machine
18: Mounting head
N: Suction nozzle
30: Barrel tube [rear end portion]
32: Suction pipe [tip portion]
34: Flange
36: Interlocking pin
38: Two-dimensional code [identifier]
50: Nozzle station
NT: Nozzle tray
60: Base plate
62: Cover plate
64: Placing hole [placing unit]
66: Stepped surface
76: Two-dimensional code [identifier]
80: Nozzle management machine
84: Controller [control device]
100: Nozzle storing device
102: Tray storing device
104: Nozzle transfer device [device for performing treatment on nozzles] [defective nozzle transporting device]
106: First nozzle inspecting device [device for performing treatment on nozzles]
108: Second nozzle inspecting device [device for performing treatment on nozzles]
110: Nozzle washing device [device for performing treatment on nozzles]
112: Nozzle drying device
114: First pallet transfer device [nozzle transfer device]
116: Second pallet transfer device [nozzle transfer device]
118: Third pallet transfer device [nozzle transfer device]
120: Fourth pallet transfer device [nozzle transfer device]
122: Tray transfer device
134: Pallet transfer device [pallet circulating device]
NP: Nozzle pallet
140: Base plate
142: Cover plate
144: Placing hole [placing unit]
146: Stepped surface
156: Two-dimensional code [identifier]
158: Reference nozzle [reference target]
160: Reference pipe [reference target] [simulated object]
190: Tray moving device [tray circulating device]
202: Fixed stage
204: Movable stage
210: Transfer head
212: Head moving device [holding jig moving device]
218: Holding chuck [nozzle holding jig]
220: Camera [identifier reader]
224: Defective box [defective nozzle indwelling device]
226: Space [indwelling unit]
232: Camera device
234: Load measuring device
235: Inspecting unit
236: Unit moving device
270: Inspection head
272: Head moving device
274: Air carrying device
276: Camera
302: Upper portion washing unit
304: Lower portion washing unit
310: Y direction moving mechanism
312: Injection hole
314: Air blowing pipe
330: Rail
332: Moving mechanism
334: Guide
336: Transporting unit
338: Guide
340: Transporting unit
400: Nozzle information memory section
402: Nozzle storage control unit
404: Nozzle setting control unit
406: Nozzle resetting control unit
408: Nozzle washing control unit
410: First nozzle inspection control unit
412: Second nozzle inspection control unit
414: Defective nozzle transport control unit
416: Tray exchange control unit
418: Reference target referring defective nozzle determination unit
420: Reference target dependent inspection preparation processing unit

## Claims

1. A nozzle management machine (80) which is configured to manage suction nozzles (N) used to hold an electrical component (P) in an electrical component mounting machine (10), the nozzle management machine (80) comprising:
a nozzle storing device (100) that is configured to store a plurality of suction nozzles (N),
wherein the nozzle storing device (100) includes a plurality of pallets (NP) on which the plurality of suction nozzles (N) are respectively placed, and
a pallet moving device (134) that is configured to move the plurality of pallets (NP) in the nozzle storing device (100),
the nozzle management machine (80) **being characterized by** including
a device (104, 106, 108, 110) for performing a treatment on nozzles (N) that is configured to perform a certain treatment on the suction nozzles (N) placed or to be placed in the nozzle storing device (100), and
a pallet transfer device (114, 116, 118, 120) that is configured to transfer one of the plurality of pallets (NP) moved to a set position by the pallet moving device (134) to the device (104, 106, 108, 110) for performing a treatment on nozzles (N).

2. The nozzle management machine (80) according to claim 1, wherein one or more of the plurality of pallets (NP) is configured such that plural kinds of nozzles (N) are placed thereon.

3. The nozzle management machine (80) according to claim 2, wherein the pallet moving device (134) is a pallet circulating device (134) that is configured to circulate and to move the plurality of pallets (NP) at the same time.

4. The nozzle management machine (80) according to any one of claims 1 to 3,
wherein the electrical component mounting machine (10) is configured such that one or more suction nozzles (N) used in the electrical component mounting machine (10) are placed on a nozzle tray (NT) which is detachably disposed in the electrical component mounting machine (10), and
the nozzle management machine (80) includes a nozzle transfer device (104) that is configured to perform at least one of setting transfer transferring the suction nozzle (N) stored in the nozzle storing device (100) to the nozzle tray (NT) positioned in the set position and storage transfer transferring the suction nozzle (N) placed on the nozzle tray (NT) positioned in the set position from the nozzle tray (NT) so as to be stored in the nozzle storing device (100).

5. The nozzle management machine (80) according to claim 4,
wherein the nozzle transfer device (114) is configured to transfer suction nozzles (N) being placed on one of the plurality of pallets (NP) transferred to a position, in which nozzles (N) are transferred by the nozzle transfer device (104), by the pallet transfer device (114) at the time of setting transfer in a case where the nozzle transfer device (104) is configured to perform setting transfer, and to transfer suction nozzles (N) to one of the plurality of pallets (NP) transferred to a position, in which nozzles (N) are transferred by the nozzle transfer device (114) from the nozzle storing device (100), by the pallet transfer device (114) at the time of storage transfer in a case where the nozzle transfer device (104) is configured to perform storage transfer.

6. The nozzle management machine (80) according to claim 4 or 5, wherein the nozzle transfer device (104) is configured to perform at least the storage transfer,
the nozzle management machine (80) includes a control device (84) that is configured to control its own device,
the control device (84) includes a nozzle information memory section (400) that is configured to store specific information related to each of the plurality of suction nozzles (N) stored in the nozzle storing device (100) in association with storage positions in each of the nozzle storing devices (100) and a nozzle storage control unit (402) that is configured to allow the suction nozzles (N) being placed on the nozzle tray (NT) positioned in the set position to be transferred from the nozzle tray (NT) by controlling the nozzle transfer device (104) and to store specific information of the transferred suction nozzles (N) in association with the storage positions of the suction nozzles (N) to the nozzle information memory section (400).

7. The nozzle management machine (80) according to any one of claims 4 to 6,
wherein the nozzle transfer device (104) is configured to perform at least the setting transfer, the nozzle management machine (80) includes a control device (84) that is configured to control its own device, and
the control device (84) includes a nozzle information memory section (400) that is configured to store specific information related to each of the plurality of suction nozzles (N) stored in the nozzle storing device (100) in association with the storage positions in each of the nozzle storing device (100) and a nozzle setting control unit (404) that is configured to allow the suction nozzles (N), which is to be placed on the nozzle tray (NT), to be transferred to the nozzle tray (NT) positioned in the set position by controlling the nozzle transfer device (104) based on the specific information related to the plurality of suction nozzles (N) stored in the nozzle information memory section (400).

8. The nozzle management machine (80) according to any one of claims 4 to 7,
wherein the nozzle transfer device (104) is configured to perform at least the storage transfer and the setting transfer,
the nozzle management machine (80) includes a control device (84) that is configured to control its own device, and
the control device (84) includes a nozzle information memory section (400) that is configured to store specific information related to each of the plurality of suction nozzles (N) stored in the nozzle storing device (100) in association with the storage positions in each of the nozzle storing device (100) and a nozzle resetting control unit (406) .that is configured to allow the suction nozzles (N) being placed on the nozzle tray (NT) positioned in the set position to be transferred from the nozzle tray (NT) by controlling the nozzle transfer device (104) and to allow suction nozzles (N), which have the same type as that of the transferred suction nozzles (N) and are stored in the nozzle storing device (100), to be transferred to the nozzle tray (NT) positioned in the set position based on the specific information of the plurality of suction nozzles (N) stored in the nozzle information memory section (400).

9. The nozzle management machine (80) according to claim 8, wherein the nozzle resetting control unit (406) is configured to allow other suction nozzles (N) to be transferred in place of the transferred suction nozzles (N) to the nozzle tray (NT) positioned in the set position.

10. The nozzle management machine (80) according to any one of claims 6 to 9,
wherein the nozzle management machine (80) includes a tray storing device (102) that is configured to store a plurality of nozzle trays (NT), each of which is the nozzle tray (NT), and a tray transfer device (122) that is configured to transfer one nozzle tray (NT) between the set position and the tray storing device (102), and
the control device (84) includes a tray exchange control unit (416) that is configured to allow the nozzle tray (NT) to be exchanged for a nozzle tray (NT) stored in the tray storing device (102) by controlling the tray transfer device (122) in a case where it is determined that a failure occurs in the nozzle tray (NT).

11. The nozzle management machine (80) according to any one of claims 1 to 10, wherein the nozzle management machine (80) includes a nozzle inspecting device (106, 108) that is configured to inspect suction nozzles (N).

12. The nozzle management machine (80) according to claim 11,
wherein the pallet transfer device (116, 118) is configured to transfer the plurality of suction nozzles (N) by transferring one of the plurality of pallets (NP) to the nozzle inspecting device (106, 108) from the nozzle storing device (100), and
the nozzle inspecting device (106, 108) is configured to inspect the plurality of suction nozzles (N) being placed on one of the plurality of pallets (NP) in a state in which the plurality of suction nozzles (N) are placed on the one pallet (NP).

13. The nozzle management machine (80) according to claim 11 or 12, wherein a reference target (158, 160) to be referenced at the time of inspection performed by the nozzle inspection device (106, 108) is provided.

14. The nozzle management machine (80) according to claim 13,
wherein the pallet transfer device (116, 118) is configured to transfer the plurality of suction nozzles (N) by transferring one of the plurality of pallets (NP) to the nozzle inspecting device (106, 108) from the nozzle storing device (100),
the nozzle inspecting device (106, 108) is configured to inspect the plurality of suction nozzles (N) being placed on one of the plurality of pallets (NP) in a state in which the plurality of suction nozzles (N) are placed on the one pallet (NP), and
the reference target (158, 160) is provided in at least one of the plurality of pallets (NP).

15. The nozzle management machine (80) according to claim 13 or 14,
wherein the reference target (158, 160) is configured such that excellent inspection results are constantly obtained,
the nozzle management machine (80) includes a control device (84) that is configured to control its own device,
the control device (84) includes a reference target referring defective nozzle determination unit (418) that is configured to determine a suction nozzle (N) as a defective nozzle (N) under the conditions in which the inspection result of the suction nozzle (N) obtained by the nozzle inspecting device (106, 108) is "defective" and the inspection result of the reference target (158, 160) is "excellent."

16. The nozzle management machine (80) according to any one of claims 11 to 15,
wherein the nozzle management machine (80) includes a defective nozzle indwelling device (224) that is configured to indwell defective nozzles (N) which are suction nozzles (N) determined as defectives based on the inspection results obtained by the nozzle inspecting device (106, 108), and
the defective nozzle indwelling device (224) includes a plurality of indwelling unit (226) for indwelling defective nozzles (N) which are different from one another in terms of inspection items that are determined to be defective.

17. The nozzle management machine (80) according to claim 16,
wherein the nozzle management machine (80) includes a defective nozzle transporting device (104) that is configured to transport defective nozzles (N) to the defective nozzle indwelling device (224) and a control device (84) that is configured to control its own device, and
the control device (84) includes a defective nozzle transportation control unit (224) that is configured to allow defective nozzles (N) to be transported to one of the plurality of indwelling units (226) corresponding to the inspection items that are determined as defective on the defective nozzles (N) by controlling the defective nozzle transporting device (104).

18. The nozzle management machine (80) according to any one of claims 1 to 17, further comprising a nozzle washing device (110) that is configured to wash suction nozzles (N).

19. The nozzle management machine (80) according to claim 18, wherein the nozzle washing device (110) is configured to wash suction nozzles (N) by injecting high-pressure water toward the suction nozzles (N).

20. The nozzle management machine (80) according to claim 18 or 19,
wherein the pallet transfer device (120) is configured to transfer the plurality of suction nozzles (N) by transferring one of the plurality of pallets (NP) to the nozzle washing device (110) from the nozzle storing device (100), and
the nozzle washing device (110) is configured to wash the plurality of suction nozzles (N) being placed on one of the plurality of pallets (NP) in a state in which the plurality of suction nozzles (N) are placed on the one pallet (NP).

## Patentansprüche

1. Vorrichtung (80) zur Verwaltung von Düsen, die so eingerichtet ist, dass sie Saugdüsen (N) verwaltet, die in einer Maschine (10) zum Montieren elektrischer Bauteile zum Halten eines elektrischen Bauteils (P) eingesetzt wird, wobei die Vorrichtung (80) zur Verwaltung von Düsen umfasst:
eine Einrichtung (100) zum Aufbewahren von Düsen, die zum Aufbewahren einer Vielzahl von Saugdüsen (N) eingerichtet ist,
wobei die Einrichtung (100) zum Aufbewahren von Düsen eine Vielzahl von Paletten (NP) enthält, auf die die Vielzahl von Saugdüsen (N) jeweils aufgesetzt sind, und
eine Einrichtung (134) zum Bewegen von Paletten, die zum Bewegen der Vielzahl von Paletten (NP) in der Einrichtung (100) zum Aufbewahren von Düsen eingerichtet ist,
wobei die Vorrichtung (80) zur Verwaltung von Düsen **dadurch gekennzeichnet ist, dass** sie
eine Einrichtung (104, 106, 108, 110) zum Durchführen einer Behandlung an Düsen (N), die zum Durchführen einer bestimmten Behandlung an den Saugdüsen (N) eingerichtet ist, die an der Einrichtung (100) zum Aufbewahren von Düsen aufgesetzt sind oder aufgesetzt werden sollen, sowie
eine Einrichtung (114, 116, 118, 120) zum Überführen von Paletten enthält, die so eingerichtet ist, dass sie eine durch die Einrichtung (134) zum Bewegen von Paletten an eine Bereitschaftsposition bewegte der Vielzahl von Paletten (NP) zu der Vorrichtung (104, 106, 108, 110) zum Durchführen einer Behandlung an Düsen (N) überführt.

2. Vorrichtung (80) zur Verwaltung von Düsen nach Anspruch 1, wobei eine oder mehrere der Vielzahl von Paletten (NP) so eingerichtet ist/sind, dass mehrere Arten von Düsen (N) darauf aufgesetzt werden.

3. Vorrichtung (80) zur Verwaltung von Düsen nach Anspruch 2, wobei die Einrichtung (134) zum Bewegen von Paletten eine Einrichtung (134) für Umlauf von Paletten ist, die so eingerichtet ist, dass sie die Vielzahl von Paletten (NP) gleichzeitig umlaufen lässt und bewegt.

4. Vorrichtung (80) zur Verwaltung von Düsen nach einem der Ansprüche 1 bis 3,
wobei die Maschine (10) zum Montieren elektrischer Bauteile so eingerichtet ist, dass eine oder mehrere Saugdüse/n (N), die in der Maschine (10) zum Montieren elektrischer Bauteile verwendet werden, auf eine Düsen-Ablage (NT) aufgesetzt werden, die entnehmbar in der Maschine (10) zum Montieren elektrischer Bauteile angeordnet ist, und
die Vorrichtung (80) zur Verwaltung von Düsen eine Einrichtung (104) zur Überführung von Düsen umfasst, die so eingerichtet ist, dass sie Bereitschafts-Überführung, mit der die in der Einrichtung (100) zum Aufbewahren von Düsen aufbewahrte Saugdüse (N) zu der an der Bereitschaftsposition befindlichen Düsen-Ablage (NT) überführt, oder/und Aufbewahrungs-Überführung durchführt, mit der die Saugdüse (N), die auf die an der Bereitschaftsposition befindliche Düsen-Ablage (NT) aufgesetzt ist, von der Düsen-Ablage (NT) so überführt, dass sie in der Einrichtung (100) zum Aufbewahren von Düsen aufbewahrt wird.

5. Vorrichtung (80) zur Verwaltung von Düsen nach Anspruch 4,
wobei die Einrichtung (114) zur Überführung von Düsen so eingerichtet ist, dass sie Saugdüsen (N), die auf eine der Vielzahl von Paletten (NP) aufgesetzt sind, die durch die Einrichtung (114) zu Überführung von Paletten bei Bereitschafts-Überführung dann, wenn die Einrichtung (104) zur Überführung von Düsen so eingerichtet ist, dass sie Bereitschafts-Überführung durchführt, an eine Position überführt ist, an der Düsen (N) durch die Einrichtung (104) zur Überführung von Düsen überführt werden, und Saugdüsen (N) zu einer der Vielzahl von Paletten (NP) überführt, die durch die Einrichtung (114) zur Überführung von Paletten bei Aufbewahrungs-Überführung dann, wenn die Einrichtung (104) zur Überführung von Düsen so eingerichtet ist, dass sie Aufbewahrungs-Überführung durchführt, an eine Position überführt ist, an der Düsen (N) durch die Einrichtung (114) zur Überführung von Paletten von der Einrichtung (100) zum Aufbewahren von Düsen überführt werden.

6. Vorrichtung (80) zur Verwaltung von Düsen nach Anspruch 4 oder 5, wobei die Einrichtung (104) zur Überführung von Düsen so eingerichtet ist, dass sie wenigstens die Aufbewahrungs-Überführung durchführt,
die Vorrichtung (80) zur Verwaltung von Düsen eine Steuerungseinrichtung (84) enthält, die so eingerichtet ist, dass sie ihre eigene Einrichtung steuert,
die Steuerungseinrichtung (84) einen Speicher-Teilabschnitt (400) für Düsen-Informationen, der so eingerichtet ist, dass er spezifische Informationen, die sich auf jede der Vielzahl in der Einrichtung (100) zum Aufbewahren von Düsen aufbewahrten Saugdüsen (N) beziehen, in Verbindung mit Aufbewahrungs-Positionen in jeder der Einrichtungen (100) zum Aufbewahren von Düsen speichert, sowie eine Einheit (402) zur Steuerung der Aufbewahrung von Düsen einschließt, die so eingerichtet ist, dass sie zulässt, dass die Saugdüsen (N), die auf die Düsen-Ablage (NT) aufgesetzt sind, die sich an der Bereitschaftsposition befindet, von der Düsen-Ablage (NT) überführt werden, indem sie die Einrichtung (104) zur Überführung von Düsen steuert, und spezifische Informationen der überführten Saugdüsen (N) in Verbindung mit den Aufbewahrungs-Positionen der Saugdüsen (N) in dem Speicher-Teilabschnitt (400) für Düsen-Informationen speichert.

7. Vorrichtung (80) zur Verwaltung von Düsen nach einem der Ansprüche 4 bis 6,
wobei die Einrichtung (104) zur Überführung von Düsen so eingerichtet ist, dass sie wenigstens die Bereitschafts-Überführung durchführt, die Vorrichtung (80) zur Verwaltung von Düsen eine Steuerungseinrichtung (84) enthält, die so eingerichtet ist, dass sie ihre eigene Einrichtung steuert, und
die Steuerungseinrichtung (84) einen Speicher-Teilabschnitt (400) für Düsen-Informationen, der so eingerichtet ist, dass er spezifische Informationen, die sich auf jede der Vielzahl in der Einrichtung (100) zum Aufbewahren von Düsen aufbewahrten Saugdüsen (N) beziehen, in Verbindung mit den Aufbewahrungs-Positionen in jeder der Einrichtungen (100) zum Aufbewahren von Düsen speichert, sowie eine Einheit (404) zur Steuerung der Bereitschaftseinstellung von Düsen einschließt, die so eingerichtet ist, dass sie zulässt, dass die Saugdüsen (N), die auf die Düsen-Ablage (NT) aufgesetzt werden sollen, zu der Düsen-Ablage (NT) überführt werden, die sich an der Bereitschaftsposition befindet, indem sie die Einrichtung (104) zur Überführung von Düsen auf Basis der in dem Speicher-Teilabschnitt (400) für Düsen-Informationen gespeicherten spezifischen Informationen steuert, die sich auf die Vielzahl von Saugdüsen (N) beziehen.

8. Vorrichtung (80) zur Verwaltung von Düsen nach einem der Ansprüche 4 bis 7,
wobei die Einrichtung (104) zur Überführung von Düsen so eingerichtet ist, dass sie wenigstens die Aufbewahrungs-Überführung und die Bereitschafts-Überführung durchführt, die Vorrichtung (80) zur Verwaltung von Düsen eine Steuerungseinrichtung (84) enthält, die so eingerichtet ist, dass sie ihre eigene Einrichtung steuert,
die Steuerungseinrichtung (84) einen Speicher-Teilabschnitt (400) für Düsen-Informationen, der so eingerichtet ist, dass er spezifische Informationen, die sich auf jede der Vielzahl in der Einrichtung (100) zum Aufbewahren von Düsen aufbewahrten Saugdüsen (N) beziehen, in Verbindung mit den Aufbewahrungs-Positionen in jeder der Einrichtungen (100) zum Aufbewahren von Düsen speichert, sowie eine Einheit (406) zur Steuerung des Rückführens von Düsen einschließt, die so eingerichtet ist, dass sie zulässt, dass die Saugdüsen (N), die auf die Düsen-Ablage (NT) aufgesetzt sind, die sich an der Bereitschaftsposition befindet, von der Düsen-Ablage (NT) überführt werden, indem sie die Einrichtung (104) zur Überführung von Düsen auf Basis der in dem Speicher-Teilabschnitt (400) für Düsen-Informationen gespeicherten spezifischen Informationen der Vielzahl von Saugdüsen (N) steuert und zulässt, dass Saugdüsen, die von dem gleichen Typ sind wie die überführten Saugdüsen (N) und in der Einrichtung (100) zum Aufbewahren von Düsen aufbewahrt sind, zu der Düsen-Ablage überführt werden, die sich an der Bereitschaftsposition befindet.

9. Vorrichtung (80) zur Verwaltung von Düsen nach Anspruch 8, wobei die Einheit (406) zur Steuerung des Rückführens von Düsen so eingerichtet ist, dass sie zulässt, dass anstelle der überführten Saugdüsen (N) andere Saugdüsen (N) zu der an der Bereitschaftsposition befindlichen Düsen-Ablage (NT) überführt werden.

10. Vorrichtung (80) zur Verwaltung von Düsen nach einem der Ansprüche 6 bis 9,
wobei die Vorrichtung (80) zur Verwaltung von Düsen eine Einrichtung (102) zum Aufbewahren von Ablagen, die so eingerichtet ist, dass sie eine Vielzahl von Düsen-Ablagen (NT) aufbewahrt, von denen jede die Düsen-Ablage (NT) ist, sowie eine Einrichtung (122) zur Überführung von Ablagen einschließt, die so eingerichtet ist, dass sie eine Düsen-Ablage (NT) zwischen der Bereitschaftsposition und der Einrichtung (102) zum Aufbewahren von Ablagen überführt, und
die Steuerungseinrichtung (84) eine Einheit (416) zur Steuerung des Austauschs von Ablagen umfasst, die so eingerichtet ist, dass sie zulässt, dass die Düsen-Ablage (NT) gegen eine in der Einrichtung (102) zum Aufbewahren von Ablagen aufbewahrte Düsen-Ablage (NT) ausgetauscht wird, indem sie die Einrichtung (122) zur Überführung von Ablagen dann steuert, wenn festgestellt wird, dass ein Fehler an der Düsen-Ablage (NT) auftritt.

11. Vorrichtung (80) zur Verwaltung von Düsen nach einem der Ansprüche 1 bis 10, wobei die Vorrichtung (80) zur Verwaltung von Düsen eine Einrichtung (106, 108) zum Prüfen von Düsen enthält, die so eingerichtet ist, dass sie Saugdüsen (N) prüft.

12. Vorrichtung (80) zur Verwaltung von Düsen nach Anspruch 11,
wobei die Einrichtung (116, 118) zur Überführung von Paletten so eingerichtet ist, dass sie die Vielzahl von Saugdüsen (N) überführt, indem sie eine der Vielzahl von Paletten (NP) von der Einrichtung (100) zum Aufbewahren von Düsen zu der Einrichtung (106, 108) zum Prüfen von Düsen überführt, und
die Einrichtung (106, 108) zum Prüfen von Düsen so eingerichtet ist, dass sie die Vielzahl von Saugdüsen (N), die auf eine der Vielzahl von Paletten (NP) aufgesetzt sind, in einem Zustand prüft, in dem die Vielzahl von Saugdüsen (N) auf die eine Palette (NP) aufgesetzt sind.

13. Vorrichtung (80) zur Verwaltung von Düsen nach Anspruch 11 oder 12, wobei ein Bezugs-Ziel (158, 160) vorhanden ist, auf das bei durch die Einrichtung (106, 108) zum Prüfen von Düsen durchgeführter Prüfung Bezug genommen wird.

14. Vorrichtung (80) zur Verwaltung von Düsen nach Anspruch 13,
wobei die Einrichtung (116, 118) zur Überführung von Paletten so eingerichtet ist, dass sie die Vielzahl von Saugdüsen (N) überführt, indem sie eine der Vielzahl von Paletten (NP) von der Einrichtung (100) zum Aufbewahren von Düsen zu der Einrichtung (106, 108) zum Prüfen von Düsen überführt,
die Einrichtung (106, 108) zum Prüfen von Düsen so eingerichtet ist, dass sie die Vielzahl von Saugdüsen (N), die auf eine der Vielzahl von Paletten (NP) aufgesetzt sind, in einem Zustand prüft, in dem die Vielzahl von Saugdüsen (N) auf die eine Palette (NP) aufgesetzt sind, und
das Bezugs-Ziel (158, 160) an wenigstens einer der Vielzahl von Paletten (NP) vorhanden ist.

15. Vorrichtung (80) zur Verwaltung von Düsen nach Anspruch 13 oder 14,
wobei das Bezugs-Ziel (158, 160) so eingerichtet ist, dass konstant hervorragende Prüfungsergebnisse erzielt werden,
die Vorrichtung (80) zur Verwaltung von Düsen eine Steuerungseinrichtung (84) enthält, die so eingerichtet ist, dass sie ihre eigene Einrichtung steuert,
die Steuerungseinrichtung (84) eine Einheit (418) zur Bestimmung einer defekten Düse enthält, die auf das Bezugs-Ziel Bezug nimmt und so eingerichtet ist, dass sie eine Saugdüse (N) unter der Bedingung als eine defekte Düse (N) bestimmt, dass das durch die Einrichtung (106, 108) zum Prüfen von Düsen erzielte Prüfungsergebnis der Saugdüse (N) "defekt" ist und das Prüfungsergebnis des Bezugs-Ziels (158, 160) "hervorragend" ist.

16. Vorrichtung (80) zur Verwaltung von Düsen nach einem der Ansprüche 11 bis 15,
wobei die Vorrichtung (80) zur Verwaltung von Düsen eine Einrichtung (224) zum Aufnehmen defekter Düsen aufweist, die zum Aufnehmen defekter Düsen (N) eingerichtet ist, die Saugdüsen (N) sind, die auf Basis der durch die Einrichtung (106, 108) zum Prüfen von Düsen erzielten Prüfungsergebnisse als defekt bestimmt werden, und
die Einrichtung (224) zum Aufnehmen defekter Düsen eine Vielzahl von Aufnahme-Einheiten (226) zum Aufnehmen defekter Düsen (N) aufweist, die sich voneinander in Bezug auf Prüfungsgegenstände unterscheiden, die als defekt bestimmt werden.

17. Vorrichtung (80) zur Verwaltung von Düsen nach Anspruch 16,
wobei die Vorrichtung (80) zur Verwaltung von Düsen eine Einrichtung (104) zum Transportieren defekter Düsen, die zum Transportieren defekter Düsen (N) zu der Einrichtung (224) zum Aufnehmen defekter Düsen eingerichtet ist, sowie eine Steuerungseinrichtung (84) einschließt, die zum Steuern ihrer eigenen Einrichtung eingerichtet ist, und
die Steuerungseinrichtung (84) eine Einheit (224) zur Steuerung von Transport defekter Düsen einschließt, die so eingerichtet ist, dass sie zulässt, dass defekte Düsen (N) zu einer der Vielzahl von Aufnahme-Einheiten (226) transportiert werden, die den Prüfungsgegenständen entsprechen, die an den defekten Düsen (N) als defekt bestimmt werden, indem sie die Einrichtung (104) zum Transportieren defekter Düsen steuert.

18. Vorrichtung (80) zur Verwaltung von Düsen nach einem der Ansprüche 1 bis 17, die des Weiteren eine Einrichtung (110) zum Spülen von Düsen umfasst, die zum Spülen von Saugdüsen (N) eingerichtet ist.

19. Vorrichtung (80) zum Verwalten von Düsen nach Anspruch 18, wobei die Einrichtung (110) zum Spülen von Düsen so eingerichtet ist, dass sie Saugdüsen (N) spült, indem sie Hochdruckwasser auf die Saugdüsen (N) zu spritzt.

20. Vorrichtung (80) zur Verwaltung von Düsen nach Anspruch 18 oder 19,
wobei die Einrichtung (120) zur Überführung von Paletten so eingerichtet ist, dass sie die Vielzahl von Saugdüsen (N) überführt, indem sie eine der Vielzahl von Paletten (NP) von der Einrichtung (100) zum Aufbewahren von Düsen zu der Einrichtung (110) zum Spülen von Düsen überführt, und
die Einrichtung (110) zum Spülen von Düsen so eingerichtet ist, dass sie die Vielzahl von Saugdüsen (N), die auf eine der Vielzahl von Paletten (NP) aufgesetzt sind, in einem Zustand spült, in dem die Vielzahl von Saugdüsen (N) auf die eine Palette (NP) aufgesetzt sind.

## Revendications

1. Machine de gestion de buses (80) qui est configurée pour gérer des buses d'aspiration (N) utilisées pour retenir un composant électrique (P) dans une machine de montage de composants électriques (10), la machine de gestion de buses (80) comprenant :
un dispositif de stockage de buses (100) qui est configuré pour stocker une pluralité de buses d'aspiration (N),
dans laquelle le dispositif de stockage de buses (100) inclut une pluralité de plateaux (NP) sur lesquels sont placées respectivement les différentes buses d'aspiration (N), et
un dispositif de déplacement de plateaux (134) qui est configuré pour déplacer la pluralité de plateaux (NP) dans le dispositif de stockage de buses (100),
la machine de gestion de buses (80) **étant caractérisée en ce qu'elle** inclut :
un dispositif (104, 106, 108, 110) destiné à effectuer un traitement sur les buses (N), lequel est configuré pour effectuer un certain traitement sur les buses d'aspiration (N) placées ou devant être placées dans le dispositif de stockage de buses (100), et
un dispositif de transfert de plateaux (114, 116, 118, 120) qui est configuré pour transférer vers le dispositif (104, 106, 108, 110) l'un de la pluralité de plateaux (NP) déplacés vers une position définie grâce au dispositif de déplacement de plateaux (134) afin d'effectuer un traitement sur des buses (N).

2. Machine de gestion de buses (80) selon la revendication 1, dans laquelle un ou plusieurs de la pluralité de plateaux (NP) sont configurés de sorte à ce que plusieurs types de buses (N) soient placées sur ceux-ci.

3. Machine de gestion de buses (80) selon la revendication 2, dans laquelle le dispositif de déplacement de plateaux (134) est un dispositif de mise en circulation de plateaux (134) qui est configuré pour faire circuler et pour déplacer en même temps la pluralité de plateaux (NP).

4. Machine de gestion de buses (80) selon l'une quelconque des revendications 1 à 3,
dans laquelle la machine de montage de composants électriques (10) est configurée de sorte à ce qu'une ou plusieurs buses d'aspiration (N) utilisées dans la machine de montage de composants électriques (10) soient placées sur un bac de buses (NT) qui est disposé tout en étant démontable dans la machine de montage de composants électriques (10), et
la machine de gestion de buses (80) inclut un dispositif de transfert de buse (104) qui est configuré pour effectuer au moins l'un d'un transfert de réglage qui transfère la buse d'aspiration (N) stockée dans le dispositif de stockage de buses (100) vers le bac de buses (NT) installé dans la position définie, et d'un transfert de stockage qui transfère la buse d'aspiration (N) placée sur le bac de buses (NT) installé dans la position définie à partir du bac de buses (NT) de sorte à la stocker dans le dispositif de stockage de buses (100).

5. Machine de gestion de buses (80) selon la revendication 4,
dans lequel le dispositif de transfert de buse (114) est configuré pour transférer des buses d'aspiration (N) placées sur l'un de la pluralité de plateaux (NP) transférés vers une position dans laquelle les buses (N) sont transférées par le dispositif de transfert de buse (104), par le dispositif de transfert de plateaux (114) à l'instant du transfert de réglage dans le cas où le dispositif de transfert de buse (104) est configuré pour effectuer un transfert de réglage, et pour transférer des buses d'aspiration (N) vers l'un de la pluralité de plateaux (NP) transférés vers une position dans laquelle les buses (N) sont transférées par le dispositif de transfert de buse (114) depuis le dispositif de stockage de buses (100), par le dispositif de transfert de plateaux (114) à l'instant d'un transfert de stockage dans le cas où le dispositif de transfert de buse (104) est configuré pour effectuer un transfert de stockage.

6. Machine de gestion de buses (80) selon la revendication 4 ou la revendication 5, dans laquelle le dispositif de transfert de buse (104) est configuré pour effectuer au moins le transfert de stockage,
la machine de gestion de buses (80) inclut un dispositif de commande (84) qui est configuré pour piloter son propre dispositif,
le dispositif de commande (84) inclut une section mémoire d'informations sur les buses (400) qui est configurée pour stocker des informations spécifiques se rapportant à chacune de la pluralité de buses d'aspiration (N) stockées dans le dispositif de stockage de buses (100) en association avec les positions de stockage dans chacun des dispositifs de stockage de buses (100), ainsi qu'une unité de commande de stockage de buses (402) qui est configurée pour autoriser le transfert des buses d'aspiration (N), placées sur le bac de buses (NT) installé dans la position de réglage, depuis le bac de buses (NT) en pilotant le dispositif de transfert de buse (104) et pour stocker sur la section mémoire d'informations sur les buses (400) des informations spécifiques des buses d'aspiration (N) transférées en association avec les positions de stockage des buses d'aspiration (N).

7. Machine de gestion de buses (80) selon l'une quelconque des revendications 4 à 6,
dans laquelle le dispositif de transfert de buse (104) est configuré pour effectuer au moins le transfert de réglage,
la machine de gestion de buses (80) inclut un dispositif de commande (84) qui est configuré pour piloter son propre dispositif, et
le dispositif de commande (84) inclut une section mémoire d'informations sur les buses (400) qui est configurée pour stocker des informations spécifiques se rapportant à chacune de la pluralité de buses d'aspiration (N) stockées dans le dispositif de stockage de buses (100) en association avec les positions de stockage dans chacun des dispositifs de stockage de buses (100), ainsi qu'une unité de commande de réglage de buses (404) qui est configurée pour autoriser le transfert des buses d'aspiration (N), qui doivent être placées sur le bac de buses (NT), vers le bac de buses (NT) installé dans la position définie en pilotant le dispositif de transfert de buse (104) sur la base des informations spécifiques se rapportant à la pluralité de buses d'aspiration (N) stockées dans la section mémoire d'informations sur les buses (400).

8. Machine de gestion de buses (80) selon l'une quelconque des revendications 4 à 7,
dans laquelle le dispositif de transfert de buse (104) est configuré pour effectuer au moins le transfert de stockage et le transfert de réglage,
la machine de gestion de buses (80) inclut un dispositif de commande (84) qui est configuré pour piloter son propre dispositif, et
le dispositif de commande (84) inclut une section mémoire d'informations sur les buses (400) qui est configurée pour stocker des informations spécifiques se rapportant à chacune de la pluralité de buses d'aspiration (N) stockées dans le dispositif de stockage de buses (100) en association avec les positions de stockage dans chacun des dispositifs de stockage de buses (100), ainsi qu'une unité de commande de réinitialisation de buses (406) qui est configurée pour autoriser le transfert des buses d'aspiration (N) placées sur le bac de buses (NT) installé dans la position définie, à partir du bac de buses (NT) en pilotant le dispositif de transfert de buse (104), ainsi que pour autoriser le transfert des buses d'aspiration (N), qui présentent le même type que celui des buses d'aspiration (N) transférées et qui sont stockées dans le dispositif de stockage de buses (100), vers le bac de buses (NT) installé dans la position définie sur la base des informations spécifiques de la pluralité de buses d'aspiration (N) stockées dans la section mémoire d'informations sur les buses (400).

9. Machine de gestion de buses (80) selon la revendication 8, dans laquelle l'unité de commande de réinitialisation de buses (406) est configurée pour autoriser le transfert d'autres buses d'aspiration (N) à la place des buses d'aspiration (N) transférées vers le bac de buses (NT) installé dans la position définie.

10. Machine de gestion de buses (80) selon l'une quelconque des revendications 6 à 9,
la machine de gestion de buses (80) incluant un dispositif de stockage de bacs (102) qui est configuré pour stocker une pluralité de bacs de buses (NT) dont chacun est le bac de buses (NT), ainsi qu'un dispositif de transfert de bac (122) qui est configuré pour transférer un bac de buses (NT) entre la position définie et le dispositif de stockage de bacs (102), et
le dispositif de commande (84) inclut une unité de commande d'échange de bacs (416) qui est configurée pour autoriser l'échange du bac de buses (NT) avec un bac de buses (NT) stocké dans le dispositif de stockage de bacs (102) en pilotant le dispositif de transfert de bac (122) dans le cas où il est déterminé qu'une défaillance s'est produite dans le bac de buses (NT).

11. Machine de gestion de buses (80) selon l'une quelconque des revendications 1 à 10, la machine de gestion de buses (80) incluant un dispositif d'inspection des buses (106, 108) qui est configuré pour inspecter les buses d'aspiration (N).

12. Machine de gestion de buses (80) selon la revendication 11,
dans laquelle le dispositif de transfert de plateaux (116, 118) est configuré pour transférer la pluralité de buses d'aspiration (N) en transférant l'un de la pluralité de plateaux (NP) vers le dispositif d'inspection de buses (106, 108) depuis le dispositif de stockage de buses (100), et
le dispositif d'inspection de buses (106, 108) est configuré pour inspecter la pluralité de buses d'aspiration (N) placées sur l'un de la pluralité de plateaux (NP) de telle sorte que la pluralité de buses d'aspiration (N) soit placée sur ledit plateau (NP).

13. Machine de gestion de buses (80) selon la revendication 11 ou la revendication 12, dans laquelle est prévue une cible de référence (158, 160) devant être référencée au moment de l'inspection effectuée par le dispositif d'inspection (106, 108).

14. Machine de gestion de buses (80) selon la revendication 13,
dans laquelle le dispositif de transfert de plateaux (116, 118) est configuré pour transférer la pluralité de buses d'aspiration (N) en transférant l'un de la pluralité de plateaux (NP) vers le dispositif d'inspection de buses (106, 108) à partir du dispositif de stockage de buses (100),
le dispositif d'inspection de buses (106, 108) est configuré pour inspecter la pluralité de buses d'aspiration (N) placée sur l'un de la pluralité de plateaux (NP) de telle sorte que la pluralité de buses d'aspiration (N) soit placée sur ledit plateau (NP), et
la cible de référence (158, 160) est prévue dans l'un de la pluralité de plateaux (NP).

15. Machine de gestion de buses (80) selon la revendication 13 ou la revendication 14,
dans laquelle la cible de référence (158, 160) est configurée de sorte à ce que des résultats inspection excellents soient obtenus de manière constante,
la machine de gestion de buses (80) inclut un dispositif de commande (84) qui est configuré pour piloter son propre dispositif,
le dispositif de commande (84) inclut une unité de détermination de buses en défaut (418) en faisant référence à la cible de référence qui est configurée pour déterminer une buse d'aspiration (N) qui est une buse en défaut (N) sous la condition que le résultat d'inspection de la buse d'aspiration (N), obtenu par le dispositif d'inspection de buses (106, 108), soit « en défaut » et que le résultat d'inspection de la cible de référence (158, 160) soit « excellent ».

16. Machine de gestion de buses (80) selon l'une quelconque des revendications 11 à 15,
la machine de gestion de buses (80) incluant un dispositif d'assignation à demeure de buses en défaut (224) qui est configuré pour assigner à demeure des buses en défaut (N) qui sont des buses d'aspiration (N) déterminées comme étant en défaut sur la base des résultats d'inspection obtenus par le dispositif d'inspection de buses (106, 108), et
le dispositif d'assignation à demeure de buses en défaut (224) inclut une pluralité d'unités d'assignation à demeure (226) destinées à assigner à demeure les buses en défaut (N) différentes les unes des autres en termes d'éléments d'inspection, qui sont déterminées comme étant en défaut.

17. Machine de gestion de buses (80) selon la revendication 16,
la machine de gestion de buses (80) incluant un dispositif de transport de buses en défaut (104) qui est configuré pour transporter les buses en défaut (N) vers le dispositif d'assignation à demeure des buses en défaut (224), ainsi qu'un dispositif de commande (84) qui est configuré pour piloter son propre dispositif, et
le dispositif de commande (84) inclut une unité de commande de transport des buses en défaut (224) qui est configurée pour autoriser le transport des buses en défaut (N) vers l'une de la pluralité d'unités d'assignation à demeure (226) correspondant aux éléments d'inspection qui sont déterminés comme étant en défaut sur les buses en défaut (N) en pilotant le dispositif de transport de buses en défaut (104) .

18. Machine de gestion de buses (80) selon l'une quelconque des revendications 1 à 17, comprenant en outre un dispositif de nettoyage de buses (110) qui est configuré pour nettoyer les buses d'aspiration (N).

19. Machine de gestion de buses (80) selon la revendication 18, dans laquelle le dispositif de nettoyage de buses (110) est configuré pour nettoyer les buses d'aspiration (N) en injectant de l'eau sous haute pression vers les buses d'aspiration (N).

20. Machine de gestion de buses (80) selon la revendication 18 ou la revendication 19,
dans lequel le dispositif de transfert de plateaux (120) est configuré pour transférer la pluralité de buses d'aspiration (N) en transférant l'un de la pluralité de plateaux (NP) vers le dispositif de nettoyage de buses (110) à partir du dispositif de stockage de buses (100), et
le dispositif de nettoyage de buses (110) est configuré pour nettoyer la pluralité de buses d'aspiration (N) placée sur l'un de la pluralité de plateaux (NP) de sorte à ce que la pluralité de buses d'aspiration (N) soit placée sur ledit plateau (NP).
